# EUROPEAN PATENT APPLICATION

(11) **EP 4 521 463 A1**
(43) Date of publication of application: **12.03.2025**
(21) Application number: 23893294.1
(22) Date of filing: 18.08.2023
(51) Int. Cl.: H01L 27/00

(54) **DISPLAY SUBSTRATE AND DISPLAY APPARATUS**

(30) Priority: 22.11.2022 WO PCT/CN2022/133485; 25.04.2023 WO PCT/CN2023/090559
(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: ZHANG, Wei, Beijing 100176 (CN); DONG, Xiangdan, Beijing 100176 (CN); WANG, Hongli, Beijing 100176 (CN); WU, Xintong, Beijing 100176 (CN); WANG, Yu, Beijing 100176 (CN); WU, Tong, Beijing 100176 (CN)
(74) Representative: Brötz, Helmut
(86) International application number: PCT/CN2023/113736
(87) International publication number: WO 2024/109196

(57) **Abstract**

A display substrate and a display apparatus. In the display substrate, at least parts of a light-emitting functional layer (130) of a sub-pixel (10) located in a second opening (420) of a pixel defining pattern (400) are separated by a defining structure (200); the sub-pixel (10) comprises a first sub-pixel (11); the second opening (420) comprises a first defining opening (421) exposing the part of the defining structure (200) surrounding a light-emitting region (101) of the first sub-pixel (11); the length of the part of the first defining opening (421) located on a first side (L11) of a first straight line (L1) is not less than the length of the part of the first defining opening (421) located on a second side (L12) of the first straight line (L1); and a line connecting the centers of at least one sub-pixel (10) and at least one adjacent sub-pixel (10) among a plurality of sub-pixels (10) does not pass through the second opening (420). It is beneficial for balancing high power consumption and brightness uniformity problems of the display substrate, as well as crosstalk between adjacent sub-pixels (10).

## Description

The present application claims the priority to PCT International Application No. PCT/CN2022/133485 filed on November 22, 2022 and the priority to PCT International Application No. PCT/CN2023/090559 filed on April 25, 2023, the contents of which are incorporated herein by reference in their entirety as a part of the present application.

### TECHNICAL FIELD

Embodiments of the present disclosure relate to a display substrate and a display device.

### BACKGROUND

Organic light-emitting diode (OLED) display products are highly favored by users because of the advantages such as rich colors, fast response time and foldability, etc. The organic light-emitting diode display device includes a tandem element. By adding at least one light-emitting layer and a charge generation layer in the tandem element, the service life and brightness of the light-emitting element are improved, and the power consumption is reduced, thus meeting the requirements of users for the service life and power consumption of the display device.

### SUMMARY

The present disclosure provides a display substrate and a display device.

The present disclosure provides a display substrate, which includes a base substrate and a plurality of sub-pixels, a pixel defining pattern and a defining structure located on the base substrate. The plurality of sub-pixels are located on the base substrate, each sub-pixel in at least part of the plurality of sub-pixels comprises a light-emitting functional layer, and the light-emitting functional layer comprises a plurality of film layers; the pixel defining pattern is located on the base substrate, the pixel defining pattern includes a plurality of first openings to define light-emitting regions of the at least part of the plurality of sub-pixels, the pixel defining pattern further includes a plurality of second openings, a portion of at least one film layer of the light-emitting functional layer located in the first opening is a continuous portion, and a portion of the at least one film layer of the light-emitting functional layer located in at least one second opening is isolated from a portion of the at least one film layer of the light-emitting functional layer located at an outer side of the at least one second opening; the defining structure is located between the light-emitting functional layer and the base substrate, a portion of the defining structure exposed by the second opening is configured to isolate the at least one film layer of the light-emitting functional layer. The plurality of sub-pixels include a first sub-pixel, the plurality of second openings include a first defining opening, and the first defining opening exposes a portion of the defining structure surrounding a light-emitting region of the first sub-pixel, a straight line passing through a center of the light-emitting region of the first sub-pixel and extending along a first direction is a first straight line, and a length of a portion of the first defining opening located at a first side of the first straight line is not less than a length of a portion of the first defining opening located at a second side of the first straight line; a center connection line of at least one sub-pixel and at least another sub-pixel adjacent thereto among the plurality of sub-pixels does not pass through any of the plurality of second openings.

For example, according to an embodiment of the present disclosure, the plurality of sub-pixels are arranged as a plurality of sub-pixel rows, sub-pixels in each sub-pixel row are arranged along a row direction, and the plurality of sub-pixel rows are arranged along a column direction; light-emitting regions of adjacent sub-pixels arranged along at least one of the row direction and the column direction are passed through by a same straight line, and the same straight line does not pass through the second opening.

For example, according to an embodiment of the present disclosure, the plurality of sub-pixels further include a second sub-pixel, the plurality of second openings further include a second defining opening, and the second defining opening exposes a portion of the defining structure surrounding a light-emitting region of the second sub-pixel, a straight line passing through a center of the light-emitting region of the second sub-pixel and extending along the first direction is a second straight line, a length of a portion of the second defining opening located at a first side of the second straight line is not less than a length of a portion of the second defining opening located at a second side of the second straight line, and a relative positional relationship between the first side and the second side of the first straight line is the same as a relative positional relationship between the first side and the second side of the second straight line.

For example, according to an embodiment of the present disclosure, a turn-on voltage of the first sub-pixel is higher than a turn-on voltage of the second sub-pixel.

For example, according to an embodiment of the present disclosure, the first defining opening is only located at the first side of the first straight line, and at least 60% of the second defining opening is located at the first side of the second straight line.

For example, according to an embodiment of the present disclosure, the light-emitting region of the first sub-pixel includes a first axis of symmetry, the light-emitting region of the second sub-pixel includes a second axis of symmetry, an area of a portion of the first defining opening located at a first side of the first axis of symmetry is not less than an area of a portion of the first defining opening located at a second side of the first axis of symmetry, an area of a portion of the second defining opening located at a first side of the second axis of symmetry is not less than an area of a portion of the second defining opening located at a second side of the second axis of symmetry, and an extending direction of the first axis of symmetry intersects with an extending direction of the second axis of symmetry.

For example, according to an embodiment of the present disclosure, each sub-pixel in the at least part of the plurality of sub-pixels further includes a pixel circuit, and a first electrode and a second electrode located at both sides of the light-emitting functional layer, the first electrode is located between the light-emitting functional layer and the base substrate, the first electrode includes a main electrode and a connection electrode, the connection electrode does not overlap with the light-emitting region in a direction perpendicular to the base substrate, the connection electrode is electrically connected with the pixel circuit through a connection via hole, and the second opening does not overlap with the connection via hole in the direction perpendicular to the base substrate.

For example, according to an embodiment of the present disclosure, the defining structure includes a first annular defining structure surrounding the main electrode of the first sub-pixel, and an area of a portion of the first annular defining structure not exposed by the first defining opening is not less than an area of a portion of the first annular defining structure exposed by the first defining opening.

For example, according to an embodiment of the present disclosure, the defining structure further includes a second annular defining structure surrounding the main electrode of the second sub-pixel, and an area of a portion of the second annular defining structure not exposed by the second defining opening is not less than an area of a portion of the second annular defining structure exposed by the second defining opening.

For example, according to an embodiment of the present disclosure, in the first sub-pixel, an included angle between a connection line from the connection via hole to the center of the light-emitting region and the first straight line is a first included angle; in the second sub-pixel, an included angle between a connection line from the connection via hole to the center of the light-emitting region and the first straight line is a second included angle; and the second included angle is greater than the first included angle.

For example, according to an embodiment of the present disclosure, in the first sub-pixel, an extension line of the connection line from the connection via hole to the center of the light-emitting region does not pass through the second opening surrounding the first sub-pixel; and in the second sub-pixel, an extension line of the connection line from the connection via hole to the center of the light-emitting region passes through the second opening surrounding the second sub-pixel.

For example, according to an embodiment of the present disclosure, any straight line extending along a second direction passes through the second defining opening surrounding a same second sub-pixel at most once, and the second direction intersects with the first direction.

For example, according to an embodiment of the present disclosure, the first defining opening surrounding a same first sub-pixel is a continuous opening or a discontinuous opening, and the second defining opening surrounding a same second sub-pixel is a continuous opening or a discontinuous opening.

For example, according to an embodiment of the present disclosure, the light-emitting region of the first sub-pixel includes four curved sides and four corners connecting the four curved sides, the four curved sides are all bent towards the center of the light-emitting region of the first sub-pixel, the first defining opening surrounds at most two curved sides of the four curved sides and at most one corner of the four corners, and the first defining opening extends along an edge of a surrounded portion of the light-emitting region of the first sub-pixel; a shape of the light-emitting region of the second sub-pixel includes an ellipse or a circle, and the second defining opening extends along an edge of a surrounded portion of the light-emitting region of the second sub-pixel.

For example, according to an embodiment of the present disclosure, the light-emitting region of the first sub-pixel includes four straight sides and four corners connecting the four straight sides, and the first defining opening surrounds at most two straight sides of the four straight sides and at most one corner of the four corners; the light-emitting region of the second sub-pixel includes four straight sides and four corners connecting the four straight sides, and the second defining opening surrounds at least two straight sides of the four straight sides and at least two corners of the four corners.

For example, according to an embodiment of the present disclosure, the light-emitting region of the first sub-pixel includes four straight sides and four corners connecting the four straight sides, and the first defining opening surrounds at least one straight side of the four straight sides and at most one corner of the four corners; the light-emitting region of the second sub-pixel includes four straight sides and four corners connecting the four straight sides, and the second defining opening surrounds at least one straight side of the four straight sides and at most one corner of the four corners.

For example, according to an embodiment of the present disclosure, a count of first sub-pixels is plural, a count of second sub-pixels is plural, and a plurality of first sub-pixels and a plurality of second sub-pixels include a first sub-pixel and a second sub-pixel adjacent to each other; one of the first defining opening and the second defining opening is arranged between the first sub-pixel and the second sub-pixel adjacent to each other, and the first defining opening between the first sub-pixel and the second sub-pixel adjacent to each other is closer to an edge of the light-emitting region of the first sub-pixel, or the second defining opening between the first sub-pixel and the second sub-pixel adjacent to each other is closer to an edge of the light-emitting region of the second sub-pixel.

For example, according to an embodiment of the present disclosure, the plurality of sub-pixels further include a third sub-pixel, the plurality of second openings further include a third defining opening, and the third defining opening exposes a portion of the defining structure surrounding a light-emitting region of the third sub-pixel, a straight line passing through a center of the light-emitting region of the third sub-pixel and extending along the first direction is a third straight line, an area of a portion of the third defining opening located at a first side of the third straight line is not less than an area of a portion of the third defining opening located at a second side of the third straight line, and a relative positional relationship between the first side and the second side of the third straight line is the same as the relative positional relationship between the first side and the second side of the first straight line.

For example, according to an embodiment of the present disclosure, the first sub-pixel is a blue sub-pixel, one of the second sub-pixel and the third sub-pixel is a red sub-pixel, and the other of the second sub-pixel and the third sub-pixel is a green sub-pixel.

For example, according to an embodiment of the present disclosure, the light-emitting region of the third sub-pixel includes a third axis of symmetry, and an area of a portion of the third defining opening located at a first side of the third axis of symmetry is not less than an area of a portion of the third defining opening located at a second side of the third axis of symmetry.

For example, according to an embodiment of the present disclosure, each sub-pixel in the at least part of the plurality of sub-pixels further includes a pixel circuit, and a first electrode and a second electrode located at both sides of the light-emitting functional layer, the first electrode is located between the light-emitting functional layer and the base substrate, the first electrode includes a main electrode and a connection electrode, the connection electrode does not overlap with the light-emitting region in a direction perpendicular to the base substrate, and the connection electrode is electrically connected with the pixel circuit; the defining structure includes a third annular defining structure surrounding the main electrode of the third sub-pixel, and an area of a portion of the third annular defining structure not exposed by the third defining opening is not less than an area of a portion of the third annular defining structure exposed by the third defining opening.

For example, according to an embodiment of the present disclosure, a count of first sub-pixels is plural, a count of second sub-pixels is plural, a count of third sub-pixels is plural, the first sub-pixels and the third sub-pixels are alternately arranged along the first direction as a first sub-pixel group, the second sub-pixels are arranged along the first direction as a second sub-pixel group, and the first sub-pixel group and the second sub-pixel group are alternately arrange along a second direction; centers of a certain first sub-pixel and a certain third sub-pixel adjacent to each other in a same first sub-pixel group, and centers of one first sub-pixel and one third sub-pixel, which are located in an adjacent first sub-pixel group and are respectively adjacent to the certain first sub-pixel and the certain third sub-pixel adjacent to each other in the second direction, are taken as four vertices of a virtual trapezoid, and one second sub-pixel is arranged in the virtual trapezoid.

For example, according to an embodiment of the present disclosure, the defining structure includes a defining connection structure stacked with the connection electrode, and the second opening extends to an edge of the defining connection structure corresponding to the connection electrodes of part of the plurality of sub-pixels.

For example, according to an embodiment of the present disclosure, the plurality of sub-pixels include a plurality of pixel units arrayed along the first direction and a second direction, each of the plurality of pixel units includes one first sub-pixel, one second sub-pixel and one third sub-pixel, and the second direction intersects with the first direction; in each of the plurality of pixel units, the second sub-pixel and the third sub-pixel are alternately arranged along the first direction, and the first sub-pixel and the third sub-pixel are alternately arranged along the second direction; in the first sub-pixel, the connection electrode is located at one side of the main electrode in the first direction; in the second sub-pixel, the connection electrode is located at one side of the main electrode in the second direction; in the third sub-pixel, the connection electrode is located at one side of the main electrode in the first direction.

For example, according to an embodiment of the present disclosure, the least one film layer of the light-emitting functional layer includes a charge generation layer, the light-emitting functional layer includes a first light-emitting layer, the charge generation layer and a second light-emitting layer which are stacked, the charge generation layer is located between the first light-emitting layer and the second light-emitting layer, and the charge generation layer is disconnected at an edge of the defining structure.

An embodiment of the present disclosure provides a display substrate, which includes a base substrate, and a plurality of sub-pixels, a pixel defining pattern and a defining structure on the base substrate. The plurality of sub-pixels are located on the base substrate, each sub-pixel in at least part of the plurality of sub-pixels includes a light-emitting functional layer, and the light-emitting functional layer includes a plurality of film layers; The pixel defining pattern is located on the base substrate, the pixel defining pattern includes a plurality of first openings to define light-emitting regions of the at least part of the plurality of sub-pixels, the pixel defining pattern further includes a plurality of second openings, a portion of at least one film layer of the light-emitting functional layer located in the first opening is a continuous portion, and a portion of the at least one film layer of the light-emitting functional layer located in at least one second opening is isolated from a portion of the at least one film layer of the light-emitting functional layer located at an outer side of the at least one second opening; the defining structure is located between the light-emitting functional layer and the base substrate, a portion of the defining structure exposed by the second opening is configured to isolate the at least one film layer of the light-emitting functional layer. The plurality of sub-pixels include a first sub-pixel and a second sub-pixel adjacent to each other, a turn-on voltage of the first sub-pixel is higher than a turn-on voltage of the second sub-pixel, and at least part of an edge of the defining structure exposed by the second opening between the first sub-pixel and the second sub-pixel is closer to a light-emitting region of the second sub-pixel.

For example, according to an embodiment of the present disclosure, the first sub-pixel is a blue sub-pixel, and the second sub-pixel is one of a red sub-pixel and a green sub-pixel.

For example, according to an embodiment of the present disclosure, the plurality of sub-pixels include a plurality of red sub-pixels and a plurality of green sub-pixels, a count of second openings surrounding a same green sub-pixel is plural, and lengths of at least two second openings surrounding the same green sub-pixel are different; a count of second openings surrounding a same red sub-pixel is plural, and lengths of at least two second openings surrounding the same red sub-pixel are the same.

For example, according to an embodiment of the present disclosure, each sub-pixel in the at least part of the plurality of sub-pixels further includes a pixel circuit, and a first electrode and a second electrode located at both sides of the light-emitting functional layer, the first electrode is located between the light-emitting functional layer and the base substrate, the first electrode includes a main electrode and a connection electrode, the connection electrode does not overlap with the light-emitting region in a direction perpendicular to the base substrate, and the connection electrode is electrically connected with the pixel circuit through a connection via hole; the plurality of green sub-pixels are arrayed along a row direction and a column direction, the connection electrode of the red sub-pixel extends along one of the row direction and the column direction, and the connection electrode of the green sub-pixel extends along the other of the row direction and the column direction.

For example, according to an embodiment of the present disclosure, the connection electrode of the red sub-pixel extends along the column direction, and the connection electrode of the green sub-pixel extends along the row direction; an extension line of an edge, extending along the column direction, of the connection electrode of the red sub-pixel does not pass through the second opening surrounding the red sub-pixel, and an extension line of an edge, extending along the row direction, of the connection electrode of the green sub-pixel passes through the second opening surrounding the green sub-pixel.

For example, according to an embodiment of the present disclosure, a count of second openings surrounding the green sub-pixel is two, a straight line passing through a center of the connection via hole of the green sub-pixel and extending along the row direction passes through only one second opening, and a straight line passing through a center of the connection via hole of the red sub-pixel and extending along the column direction does not pass through the second opening surrounding the red sub-pixel.

For example, according to an embodiment of the present disclosure, a portion of the defining structure exposed by the second opening arranged between the first sub-pixel and the second sub-pixel includes an annular defining edge, and the annular defining edge surrounds the light-emitting region of the second sub-pixel.

For example, according to an embodiment of the present disclosure, the annular defining edge is a non-closed structure.

For example, according to an embodiment of the present disclosure, the plurality of sub-pixels further include a third sub-pixel, a portion of the defining structure exposed by the second opening includes an annular defining edge, the annular defining edge surrounds a light-emitting region of one of the second sub-pixel and the third sub-pixel, or the annular defining edge surrounds light-emitting regions of the second sub-pixel and the third sub-pixel.

For example, according to an embodiment of the present disclosure, the light-emitting region of the first sub-pixel includes four curved sides and four corners connecting the four curved sides, and the four curved sides are all bent towards a center of the light-emitting region of the first sub-pixel; a shape of the light-emitting region of the second sub-pixel includes an ellipse or a circle, and the second opening surrounds an edge of the light-emitting region of the second sub-pixel.

For example, according to an embodiment of the present disclosure, blue sub-pixels and red sub-pixels are alternately arranged along a first direction as a first sub-pixel group, green sub-pixels are arranged along the first direction as a second sub-pixel group, the first sub-pixel group and the second sub-pixel group are alternately arrange along a second direction, and the second direction intersects with the first direction; centers of a certain blue sub-pixel and a certain red sub-pixel adjacent to each other in a same first sub-pixel group, and centers of one blue sub-pixel and one red sub-pixel, which are located in an adjacent first sub-pixel group and are respectively adjacent to the certain blue sub-pixel and the certain red sub-pixel adjacent to each other in the second direction, are taken as four vertices of a virtual trapezoid, and one green sub-pixel is arranged in the virtual trapezoid.

For example, according to an embodiment of the present disclosure, at least one film layer of the light-emitting functional layer includes a charge generation layer, the light-emitting functional layer includes a first light-emitting layer, the charge generation layer and a second light-emitting layer which are stacked, the charge generation layer is located between the first light-emitting layer and the second light-emitting layer, and the charge generation layer is disconnected at an edge of the defining structure.

Another embodiment of the present disclosure provides a display device, which includes any display substrate as mentioned above.

### BRIEF DESCRIPTION OF DRAWINGS

In order to clearly illustrate the technical solution of the embodiments of the present disclosure, the drawings of the embodiments will be briefly described in the following; it is obvious that the described drawings are only related to some examples of the present disclosure and thus are not limitative of the present disclosure.
FIG. 1 is a partial planar structural view of a display substrate according to an embodiment of the present disclosure.
FIG. 2 is a partial cross-sectional structural view taken along line AA' shown in FIG. 1.
FIG. 3 is a partial cross-sectional structural view taken along line BB' shown in FIG. 1.
FIG. 4 is a schematic diagram of a defining structure in the display substrate shown in FIG. 1.
FIG. 5 is a partial structural view of a display substrate according to another example of an embodiment of the present disclosure.
FIG. 6 is a schematic diagram of a defining structure in the display substrate shown in FIG. 5.
FIGS. 7-10 are partial structural views of display substrates according to different examples of an embodiment of the present disclosure.
FIGS. 11-13 are schematic diagrams of the defining structure in the display substrate shown in FIG. 7 according to different examples.
FIG. 14 is a partial structural view of a display substrate according to an example of another embodiment of the present disclosure.
FIGS. 15-17 are partial structural views of a display substrate according to different examples of another embodiment of the present disclosure.
FIGS. 18 and 19 are partial structural views of a display substrate according to different embodiments of the present disclosure.
FIG. 20 is a schematic block diagram of a display device according to another embodiment of the present disclosure.

### DETAILED DESCRIPTION

In order to make objects, technical details and advantages of the embodiments of the present disclosure apparent, the technical solutions of the embodiment will be described in a clearly and fully understandable way in connection with the drawings related to the embodiments of the present disclosure. It is obvious that the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the description and the claims of the present application for disclosure, are not intended to indicate any sequence, amount or importance, but distinguish various components. The terms "comprise," "comprising," "include," "including," etc., are intended to specify that the elements or the objects stated before these terms encompass the elements or the objects and equivalents thereof listed after these terms, but do not preclude the other elements or objects. The features "parallel", "perpendicular" and "same" used in the embodiments of the present disclosure all include features such as "parallel", "perpendicular" and "same" in the strict sense, and the cases having certain errors, such as "approximately parallel", "approximately perpendicular", "substantially the same" or the like, taking into account measurements and errors associated with the measurement of a particular quantity (e.g., limitations of the measurement system), and indicate being within an acceptable range of deviation for a particular value as determined by one of ordinary skill in the art. For example, "approximately" may indicate being within one or more standard deviations, or within 10% or 5% of the stated value. In the case that the quantity of a component is not specifically indicated below in the embodiments of the present disclosure, it means that the component may be one or more, or may be understood as at least one. "At least one" means one or more, and "plurality" means at least two. The "same layer" mentioned in this disclosure refers to the structure formed by two (or more) structures formed by the same deposition process and patterned by the same patterning process, and their materials may be the same or different.

The term "integrated structure" in the present disclosure means that two (or more) structures are formed by the same deposition process and patterned by the same patterning process, so as to be connected with each other, and their materials may be the same or different.

In research, the inventors of the present application have found that the light-emitting functional layer of the light-emitting element can include a plurality of light-emitting layers arranged in a stacked manner, with a tandem element as an example. The tandem element has the characteristics of low power consumption and long service life. However, there is a charge generation layer (CGL) between at least two light-emitting layers of the plurality of light-emitting layers in the tandem element, and the conductivity of the charge generation layer is relatively high. For example, in the case where the charge generation layer is a whole-surface film layer, two adjacent light-emitting elements have a continuous charge generation layer, and there exists a transverse charge migration phenomenon, resulting in the monochrome chromaticity shift of the display substrate in a low grayscale. For example, crosstalk is easily caused between adjacent sub-pixels, which results in color shift of the display substrate. For example, the charge generation layer is easy to cause crosstalk between sub-pixels of different colors at low brightness, resulting in low grayscale color shift.

The embodiments of the present disclosure provide a display substrate and a display device.

The display substrate provided by at least one embodiment of the present disclosure includes a base substrate, and a plurality of sub-pixels, a pixel defining pattern and a defining structure located on the base substrate. Each sub-pixel in at least part of the sub-pixels includes a light-emitting functional layer, and the light-emitting functional layer includes a plurality of film layers; the pixel defining pattern includes a plurality of first openings to define light-emitting regions of the at least part of the sub-pixels, the pixel defining pattern further includes a plurality of second openings, a portion of at least one film layer of the light-emitting functional layer located in the first opening is a continuous portion, and a portion of the at least one film layer of the light-emitting functional layer located in at least one second opening is isolated from a portion of the at least one film layer of the light-emitting functional layer located at an outer side of the at least one second opening; the defining structure is located between the light-emitting functional layer and the base substrate, and a portion of the defining structure exposed by the second opening is configured to isolate the at least one film layer of the light-emitting functional layer. The plurality of sub-pixels include a first sub-pixel, the plurality of second openings include a first defining opening, and the first defining opening exposes a portion of the defining structure surrounding a light-emitting region of the first sub-pixel; a straight line passing through a center of the light-emitting region of the first sub-pixel and extending along a first direction is a first straight line, and an area of a portion of the first defining opening located at a first side of the first straight line is not less than an area of a portion of the first defining opening located at a second side of the first straight line; a center connection line of at least one sub-pixel and a sub-pixel adjacent thereto among the plurality of sub-pixels does not pass through any of the plurality of second openings.

In the display substrate provided by the present disclosure, by setting the positional relationship between the first defining opening and the light-emitting region of the first sub-pixel, and the positional relationship between the center connection line of adjacent sub-pixels and the second opening, the second electrode of the first sub-pixel has a conductive channel with a larger area, so that the conductive effect of the second electrode of the first sub-pixel is improved to avoid high power consumption and brightness uniformity issues of the display substrate; and at the same time, at least one film layer of the light-emitting functional layers of adjacent sub-pixels can be effectively isolated, and crosstalk caused by the electrical connection of a common layer in the light-emitting functional layers of the two sub-pixels can be reduced as much as possible.

Another embodiment of the present disclosure provides a display substrate, which includes a base substrate, and a plurality of sub-pixels, a pixel defining pattern and a defining structure located on the base substrate. Each sub-pixel in at least part of the sub-pixels includes a light-emitting functional layer, and the light-emitting functional layer includes a plurality of film layers; the pixel defining pattern includes a plurality of first openings to define light-emitting regions of the at least part of the sub-pixels, the pixel defining pattern further includes a plurality of second openings, a portion of at least one film layer of the light-emitting functional layer located in the first opening is a continuous portion, and a portion of the at least one film layer of the light-emitting functional layer located in at least one second opening is isolated from a portion of the at least one film layer of the light-emitting functional layer located at an outer side of the at least one second opening; the defining structure is located between the light-emitting functional layer and the base substrate, and a portion of the defining structure exposed by the second opening is configured to isolate the at least one film layer of the light-emitting functional layer. The plurality of sub-pixels include a first sub-pixel and a second sub-pixel adjacent to each other, a turn-on voltage of the first sub-pixel is higher than a turn-on voltage of the second sub-pixel, and at least part of an edge of the defining structure exposed by the second opening between the first sub-pixel and the second sub-pixel is closer to a light-emitting region of the second sub-pixel.

In the display substrate provided by the present disclosure, by setting the edge of the defining structure exposed by the second opening closer to the second sub-pixel with a lower turn-on voltage, the second electrode of the first sub-pixel with a higher turn-on voltage has a conductive channel with a larger area, and the conductive effect of the second electrode of the first sub-pixel is improved, which is helpful to avoid high power consumption and brightness uniformity issues of the display substrate.

The display substrate and the display device provided by the present disclosure are described below with reference to the accompanying drawings.

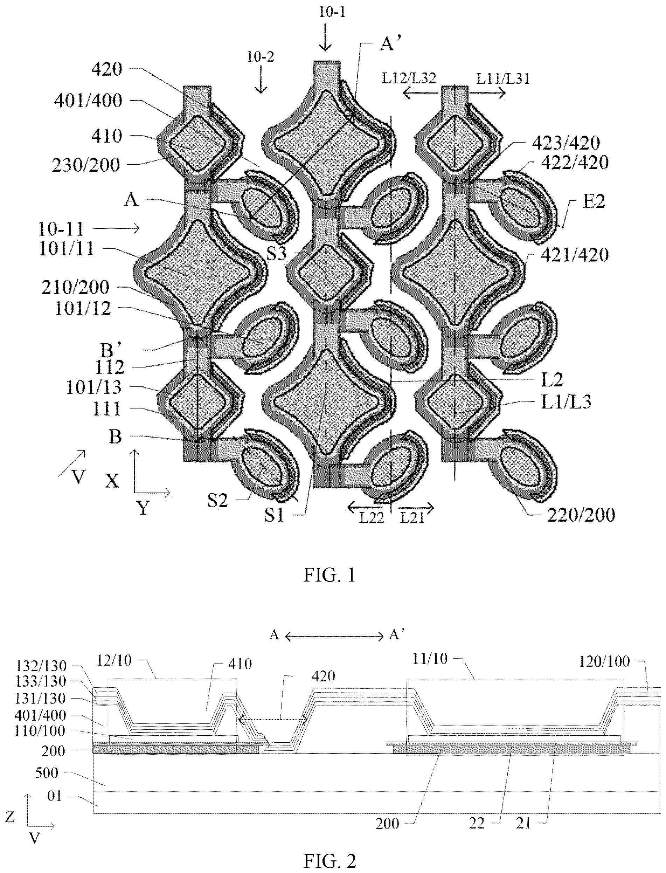

FIG. 1 is a partial planar structural view of a display substrate according to an embodiment of the present disclosure. FIG. 2 is a partial cross-sectional structural view taken along line AA' shown in FIG. 1. FIG. 1 shows a first electrode of a light-emitting element and does not show a second electrode of the light-emitting element.

As shown in FIGS. 1 and 2, the display substrate includes a base substrate 01, and a plurality of sub-pixels 10, a pixel defining pattern 400 and a defining structure 200 located on the base substrate 01. Each sub-pixel 10 in at least part of the sub-pixels 10 includes a light-emitting functional layer 130, and the light-emitting functional layer 130 includes a plurality of film layers.

For example, the sub-pixel 10 includes a light-emitting element 100; the light-emitting element 100 includes a light-emitting functional layer 130, and a first electrode 110 and a second electrode 120 located at both sides of the light-emitting functional layer 130 in the direction perpendicular to the base substrate 01; and the first electrode 110 is located between the light-emitting functional layer 130 and the base substrate 01. For example, the light-emitting functional layer 130 includes a charge generation layer 133. For example, the light-emitting element 100 can be an organic light-emitting element. For example, the display substrate includes a display region, and each sub-pixel located in the display region includes a light-emitting element.

For example, as shown in FIG. 2, the light-emitting functional layer 130 can include a first light-emitting layer (EML) 131, a charge generation layer (CGL) 133, and a second light-emitting layer (EML) 132 which are stacked, and the charge generation layer 133 is located between the first light-emitting layer 131 and the second light-emitting layer 132. The charge generation layer has a high conductivity, which can make the light-emitting functional layer have the advantages of long service life, low power consumption and capability of achieving high brightness. For example, compared with a light-emitting functional layer without a charge-generating layer, the luminous brightness of the sub-pixel can be nearly doubled by setting a charge generation layer in the light-emitting functional layer.

For example, the light-emitting element 100 of the same sub-pixel 10 can be a tandem light-emitting element, such as a Tandem OLED.

For example, the charge generation layer 133 can include an N-type charge generation layer and a P-type charge generation layer.

For example, in each sub-pixel 10, the light-emitting functional layer 130 can further include a hole injection layer (HIL), a hole transport layer (HTL), an electron transport layer (ETL) and an electron injection layer (EIL).

For example, the hole injection layer, the hole transport layer, the electron transport layer, the electron injection layer and the charge generation layer 133 are all shared film layers of the plurality of sub-pixels 10, which can be called common layers. For example, at least one film layer of the light-emitting functional layer 130 that is disconnected at the edge of the defining structure 200 can be at least one film layer of the above-mentioned common layers. By disconnecting at least one film layer of the common layers at the edge of the defining structure 200 between adjacent sub-pixels, the probability of crosstalk between adjacent sub-pixels can be reduced. For example, the common layer and the second electrode can be film layers formed by using an open mask.

For example, the second light-emitting layer 132 can be located between the first light-emitting layer 131 and the second electrode 120, and the hole injection layer can be located between the first electrode 110 and the first light-emitting layer 131. For example, an electron transport layer can be disposed between the charge generation layer 133 and the first light-emitting layer 131. For example, a hole transport layer can be disposed between the second light-emitting layer 132 and the charge generation layer 133. For example, an electron transport layer and an electron injection layer can be disposed between the second light-emitting layer 132 and the second electrode 120.

For example, in the same sub-pixel 10, the first light-emitting layer 131 and the second light-emitting layer 132 can be light-emitting layers emitting light of the same color. For example, the first light-emitting layers 131 in the sub-pixels 10 that emit light of different colors emit light of different colors. For example, the second light-emitting layers 132 in the sub-pixels 10 that emit light of different colors emit light of different colors. Of course, the embodiment of the present disclosure is not limited thereto. For example, in the same sub-pixel 10, the first light-emitting layer 131 and the second light-emitting layer 132 can be light-emitting layers that emit light of different colors. By setting the light-emitting layers that emit light of different colors in the same sub-pixel 10, the light emitted by the plurality of light-emitting layers included in the sub-pixel 10 can be mixed into white light, and the color of the emergent light of each sub-pixel can be adjusted by setting a color filter layer.

For example, the material of the electron transport layer can include aromatic heterocyclic compounds, such as: imidazole derivatives, including benzimidazole derivatives, imidazopyridine derivatives, benzimidazole phenanthridine derivatives, etc.; pyrimidine derivatives, triazine derivatives, and other zine derivatives; quinoline derivatives, isoquinoline derivatives, phenanthroline derivatives, and other compounds containing nitrogen-containing six-membered ring structures (including compounds with phosphine oxide substituents on heterocyclic rings), etc.

For example, the material of the charge generation layer 133 can be a material containing phosphorus oxide groups or a material containing triazine.

For example, the ratio of the electron mobility of the charge generation layer to the electron mobility of the electron transport layer is 10⁻² to 10².

For example, the first electrode 110 can be an anode, and the second electrode 120 can be a cathode. For example, the cathode can be made of a material with high conductivity and low work function, and for example, the cathode can be made of a metal material. For example, the anode can be formed of a transparent conductive material with high work function.

For example, as shown in FIG. 2, the orthographic projection of the second electrode 120 in at least part of the sub-pixels 10 on the base substrate 01 has a whole-surface structure. For example, the second electrode 120 can be a common electrode shared by the plurality of sub-pixels 10.

For example, as shown in FIG. 2, an insulating layer 500 is disposed between the first electrode 110 and the base substrate 01. In FIG. 2, other structures between the insulating layer 500 and the base substrate 01, such as film layers in which gate lines, data lines and other signal lines are located, as well as other insulating layers, are omitted.

As shown in FIGS. 1 and 2, the pixel defining pattern 400 includes a plurality of first openings 410 to define the light-emitting regions 101 of at least part of the sub-pixels 10. For example, one sub-pixel 10 corresponds to at least one first opening 410, the light-emitting element 100 of the sub-pixel 10 is at least partially located in the first opening 410 corresponding to the sub-pixel 10, and the first opening 410 is configured to expose the first electrode 110. For example, the first opening 410 exposes a portion of the first electrode 110. For example, one sub-pixel 10 can correspond to one first opening 410.

For example, as shown in FIGS. 1 and 2, in the case where the light-emitting functional layer 130 is formed in the first opening 410 of the pixel defining pattern 400, the first electrode 110 and the second electrode 120 located at both sides of the light-emitting functional layer 130 can drive the light-emitting functional layer 130 in the first opening 410 to emit light. For example, the light-emitting region may refer to a region where the sub-pixel effectively emits light, and the shape of the light-emitting region refers to a two-dimensional shape; for example, the shape of the light-emitting region can be the same as the shape of the first opening 410 of the pixel defining pattern 400.

For example, as shown in FIG. 2, the pixel defining pattern 400 includes a pixel defining portion 401 surrounding the first opening 410, and the material of the pixel defining portion 401 can include polyimide, acrylic or polyethylene terephthalate, etc. For example, the pixel defining portion 401 included in the pixel defining pattern 400 covers a portion of the first electrode 110.

As shown in FIGS. 1 and 2, the pixel defining pattern 400 further includes a plurality of second openings 420, a portion of at least one film layer of the light-emitting functional layer 130 located in the first opening 410 is a continuous portion, and a portion of the at least one film layer of the light-emitting functional layer 130 located in at least one second opening 420 is isolated from a portion of the at least one film layer of the light-emitting functional layer 130 located at an outer side of the at least one second opening 420. For example, the light-emitting functional layer 130 located on the pixel defining portion 401 surrounding the first opening 410 and the light-emitting functional layer 130 located in the first opening 410 can be a continuous structure, and the light-emitting functional layer 130 located on at least part of the pixel defining portion 401 surrounding the second opening 420 and the light-emitting functional layer 130 located in the second opening 420 can be two disconnected structures.

As shown in FIGS. 1 and 2, the defining structure 200 is located between the light-emitting functional layer 130 and the base substrate 01, and a portion of the defining structure 200 exposed by the second opening 420 is configured to isolate the at least one film layer of the light-emitting functional layer 130.

For example, as shown in FIGS. 1 and 2, the defining structure 200 is located between the first electrode 110 and the base substrate 01.

For example, as shown in FIGS. 1 and 2, the orthographic projection of the first opening 410 on the base substrate 01 is completely within the orthographic projection of the defining structure 200 on the base substrate 01. For example, the orthographic projection of the first electrode 110 on the base substrate 01 is completely within the orthographic projection of the defining structure 200 on the base substrate 01.

For example, as shown in FIGS. 1 and 2, at least part of the pixel defining portion 401 does not overlap with the defining structure 200 in the direction perpendicular to the base substrate 01. For example, in the direction perpendicular to the base substrate 01, the defining structure 200 includes a portion overlapped with the pixel defining portion 401, a portion overlapped with the first opening 410, and a portion overlapped with the second opening 420. For example, at least part of the pixel defining portion 401 overlaps with the gap between adjacent defining structures 200 (for example, the white gap between adjacent defining structures in FIG. 1 is covered by the pixel defining portion).

For example, as shown in FIG. 2, in the direction perpendicular to the base substrate 01, the thickness of the defining structure 200 is less than the thickness of the pixel defining portion 401.

As shown in FIGS. 1 and 2, the plurality of sub-pixels 10 include a first sub-pixel 11, the plurality of second openings 420 include a first defining opening 421, and the first defining opening 421 exposes a portion of the defining structure 200 surrounding the light-emitting region 101 of the first sub-pixel 11. For example, the defining structure 200 exposed by the first defining opening 421 is a portion that does not overlap with the first electrode of the first sub-pixel 11.

In some examples, as shown in FIGS. 1 and 2, the plurality of sub-pixels 10 include a second sub-pixel 12, the plurality of second openings 420 include a second defining opening 422, and the second defining opening 422 exposes a portion of the defining structure 200 surrounding the light-emitting region 101 of the second sub-pixel 12. For example, the defining structure 200 exposed by the second defining opening 422 is a portion that does not overlap with the first electrode of the second sub-pixel 12.

As shown in FIG. 1, a straight line passing through the center of the light-emitting region 101 of the first sub-pixel 11 and extending along the first direction is a first straight line L1. FIG. 1 illustratively shows that the first direction is the X direction, but it is not limited thereto, and the first direction can also be the Y direction or other direction.

In some examples, as shown in FIG. 1, a straight line passing through the center of the light-emitting region 101 of the second sub-pixel 12 and extending along the first direction is a second straight line L2.

For example, as shown in FIG. 1, the first straight line L1 and the second straight line L2 are straight lines separated from each other. For example, as shown in FIG. 1, the direction indicated by the arrow of the Y direction is rightward, the first side L21 of the second straight line L2 is located at the right side of the second side L22 of the second straight line L2, and the first side L11 of the first straight line L1 is located at the right side of the second side L12 of the first straight line L1.

As shown in FIG. 1, the length of a portion of the first defining opening 421 located at the first side L11 of the first straight line L1 is not less than the length of a portion of the first defining opening 421 located at the second side L12 of the first straight line L1. The length of the first defining opening can refer to the circumference of the first defining opening or the side length of the portion of the first defining opening close to the light-emitting region of the first sub-pixel. For example, the area of the portion of the first defining opening 421 located at the first side L11 of the first straight line L1 is not less than the area of the portion of the first defining opening 421 located at the second side L12 of the first straight line L1.

In some examples, as shown in FIG. 1, the length of a portion of the second defining opening 422 located at the first side L21 of the second straight line L2 is not less than the length of a portion of the second defining opening 422 located at the second side L22 of the second straight line L2, and the relative positional relationship between the first side L11 and the second side L12 of the first straight line L1 is the same as the relative positional relationship between the first side L21 and the second side L22 of the second straight line L2. The length of the second defining opening can refer to the circumference of the second defining opening or the side length of the portion of the second defining opening close to the light-emitting region of the second sub-pixel. For example, the area of the portion of the second defining opening 422 located at the first side L21 of the second straight line L2 is not less than the area of the portion of the second defining opening 422 located at the second side L22 of the second straight line L2.

For example, as shown in FIG. 1, the direction indicated by the arrow of the Y direction is rightward, the first side L11 of the first straight line L1 is located at the right side of the second side L12 of the first straight line L1, and the first side L21 of the second straight line L2 is located at the right side of the second side L22 of the second straight line L2.

For example, as shown in FIG. 1, the circumference of the portion of the first defining opening 421 located at the first side L11 of the first straight line L1 is not less than the circumference of the portion of the first defining opening 421 located at the second side L12 of the first straight line L1, and the circumference of the portion of the second defining opening 422 located at the first side L21 of the second straight line L2 is not less than the circumference of the portion of the second defining opening 422 located at the second side L22 of the second straight line L2.

For example, as shown in FIG. 1, the area of the portion of the first defining opening 421 located at the first side L11 of the first straight line L1 is greater than the area of the portion of the first defining opening 421 located at the second side L12 of the first straight line L1, and the area of the portion of the second defining opening 422 located at the first side L21 of the second straight line L2 is greater than the area of the portion of the second defining opening 422 located at the second side L22 of the second straight line L2. For example, the first defining opening 421 is completely located at the first side L11 of the first straight line L1, and the second defining opening 422 is completely located at the first side L21 of the second straight line L2.

As shown in FIG. 1, a center connection line of at least one sub-pixel 10 and a sub-pixel 10 adjacent thereto among the plurality of sub-pixels 10 does not pass through any of the plurality of second openings 420. For example, the center connection line of the light-emitting regions 101 of the first sub-pixel 11 and the third sub-pixel 13 (described later) adjacently arranged along the X direction does not pass through the second opening 420.

In the display substrate provided by the present disclosure, by setting the positional relationship between the first defining opening and the light-emitting region of the first sub-pixel, the positional relationship between the second defining opening and the light-emitting region of the second sub-pixel, and the positional relationship between the center connection line of adjacent sub-pixels and the second opening, the second electrode of the first sub-pixel has a conductive channel with a larger area, so that the conductive effect of the second electrode of the first sub-pixel is improved to avoid high power consumption and brightness uniformity issues of the display substrate; and at the same time, at least one film layer of the light-emitting functional layers of adjacent sub-pixels can be effectively disconnected, and crosstalk caused by the electrical connection of a common layer in the light-emitting functional layers of the two sub-pixels can be reduced as much as possible.

In some examples, as shown in FIG. 1, the plurality of sub-pixels are arranged as a plurality of sub-pixel rows 10-11, the sub-pixels in each sub-pixel row 10-11 are arranged along a row direction, and the plurality of sub-pixel rows 10-11 are arranged along a column direction. FIG. 1 illustratively shows that the Y direction is the row direction and the X direction is the column direction, but it is not limited thereto, and the row direction and the column direction can be interchanged.

In some examples, as shown in FIG. 1, the light-emitting regions of adjacent sub-pixels arranged along at least one of the row direction and the column direction are passed through by the same straight line, and the same straight line does not pass through the second opening 420. For example, the same straight line can be the first straight line L1.

For example, as shown in FIG. 1 and FIG. 2, in one circle of structure surrounding the light-emitting region 101 of the first sub-pixel 11 in the defining structure 200, a portion exposed by the first defining opening 421 is used to isolate at least one film layer of the light-emitting functional layer 130, and the film layers in the light-emitting functional layer 130 and the second electrode located at a portion not exposed by the first defining opening 421 are all continuously arranged. For example, in one circle of structure surrounding the light-emitting region 101 of the second sub-pixel 12 in the defining structure 200, a portion exposed by the second defining opening 422 is used to isolate at least one film layer of the light-emitting functional layer 130, and the film layers in the light-emitting functional layer 130 and the second electrode located at a portion not exposed by the second defining opening 422 are all continuously arranged.

For example, as shown in FIGS. 1 and 2, the portion of the defining structure 200 exposed by the second opening 420 includes an isolation portion, the isolation portion is arranged between at least two adjacent sub-pixels 10, and at least one film layer of the light-emitting functional layers 130 is disconnected at the edge of the isolation portion. The isolation portion used for disconnecting at least one film layer of the light-emitting functional layer is arranged between adjacent sub-pixels, which is helpful to reduce crosstalk between adjacent sub-pixels. For example, the isolation portion refers to a structure, exposed by the second opening, in the defining structure.

The "adjacent sub-pixels" in any embodiment of the present disclosure means that no other sub-pixels are arranged between these two sub-pixels. The adjacent sub-pixels can be two sub-pixels of the same color or two sub-pixels of different colors.

For example, as shown in FIG. 2, at least part of the second electrode 120 is disconnected at the edge of the defining structure 200.

For example, as shown in FIG. 2, the defining structure 200 includes a first isolation layer 21 and a second isolation layer 22 which are stacked, the first isolation layer 21 is located at one side of the second isolation layer 22 away from the base substrate 01, and the edge of the first isolation layer 21 protrudes relative to the edge of the second isolation layer 22. For example, the edge of the second isolation layer 22 shrinks inward relative to the edge of the first isolation layer 21 by a size not less than 0.05 micron, such as not less than 0.08 micron, such as not less than 0.1 micron, such as not less than 0.15 micron, such as not less than 0.2 micron, such as not less than 0.5 micron.

By setting the edge of the defining structure such that the edge of the first isolation layer protrudes relative to the edge of the second isolation layer, at least one film layer of the light-emitting functional layer can be disconnected.

For example, as shown in FIG. 2, the thickness of the defining structure 200 can be greater than 100 angstroms. For example, the thickness of the defining structure 200 can be in the range of 150-5000 angstroms. For example, the thickness of the defining structure 200 can be in the range of 200-500 angstroms. For example, the thickness of the defining structure 200 can be in the range of 300-1000 angstroms. For example, the thickness of the defining structure 200 can be in the range of 400-2000 angstroms. For example, the thickness of the defining structure 200 can be in the range of 600-1500 angstroms.

For example, as shown in FIG. 2, the material of the first isolation layer 21 is different from the material of the second isolation layer 22. The material of the first isolation layer 21 includes an inorganic non-metallic material or a metallic material, and the material of the second isolation layer 22 includes an organic material or an inorganic non-metallic material.

For example, the etching selectivity ratio of the etching solution to the material of the second isolation layer 22 is greater than the etching selectivity ratio of the etching solution to the material of the first isolation layer 21, so that the edge of the second isolation layer 22 formed after etching shrinks inward relative to the edge of the first isolation layer 21.

For example, the material of the first isolation layer 21 can include silicon nitride, silicon oxide or a combination thereof. For example, the material of the second isolation layer 22 can be the same as the material of the insulating layer 500, for example, the planarization layer 500. For example, the material of the second isolation layer 22 can include an organic material, such as polyimide, etc.

Of course, the embodiment of the present disclosure is not limited to the case where the defining structure includes a structure with two stacked layers. The defining structure can also be a structure with three stacked layers, where the layer structure farthest from the base substrate protrudes relative to the edge of the middle layer structure to realize the isolation of the light-emitting functional layer, and for example, the layer structure closest to the base substrate can also protrude relative to the edge of the middle layer structure; or, the isolation portion only includes a one-layer structure, and the edge of the structure is provided with a protruding portion used for isolating the light-emitting functional layer. For example, in the case where the defining structure includes a three-layer structure, three layers of inorganic materials with different etching rates can be adopted, or a combination of multiple layers of inorganic materials and at least one layer of an organic material can be adopted; for example, the inorganic materials can be silicon oxide, silicon nitride or a combination thereof, and for example, the organic material can be the same as the material of the planarization layer.

For example, as shown in FIG. 1, in the V direction, the size of one first opening 410 can be greater than the size of one second opening 420.

In some examples, as shown in FIG. 1, the turn-on voltage of the first sub-pixel 11 is higher than the turn-on voltage of the second sub-pixel 12.

In the display substrate provided by the present disclosure, the turn-on voltage and power consumption of the first sub-pixel are relatively high, and the voltage (e.g., VSS voltage) of the display substrate for realizing white light is limited by the voltage difference between the first electrode and the second electrode of the first sub-pixel; for example, the first sub-pixel needs to have a larger cross-voltage between the first electrode and the second electrode. By setting the positional relationship of the first defining opening surrounding the first sub-pixel and the defining structure, the second electrode of the first sub-pixel has a conductive channel with a larger area, and the conductive effect of the second electrode of the first sub-pixel is improved, which is helpful to avoid high power consumption and brightness uniformity issues of the display substrate.

FIG. 1 illustratively shows that the first sub-pixel 11 and the second sub-pixel 12 are sub-pixels configured to emit light of different colors, but it is not limited thereto, and the first sub-pixel and the second sub-pixel can also be sub-pixels configured to emit light of the same color.

In some examples, as shown in FIG. 1, the first defining opening 421 is only located at the first side L11 of the first straight line L1, and at least 60% of the second defining opening 422 is located at the first side L21 of the second straight line L2. For example, the first defining opening 421 is completely located at the first side L11 of the first straight line L1. For example, at least 65% of the second defining opening 422 is located at the first side L21 of the second straight line L2. For example, at least 70% of the second defining opening 422 is located at the first side L21 of the second straight line L2. For example, at least 75% of the second defining opening 422 is located at the first side L21 of the second straight line L2. For example, at least 80% of the second defining opening 422 is located at the first side L21 of the second straight line L2. For example, at least 85% of the second defining opening 422 is located at the first side L21 of the second straight line L2. For example, at least 90% of the second defining opening 422 is located at the first side L21 of the second straight line L2.

For example, as shown in FIG. 1, the second straight line L2 can pass through the first defining opening 421, and the area of the portion of the first defining opening 421 located at the second side of the second straight line L2 is greater than the area of the portion of the first defining opening 421 located at the first side of the second straight line L2. By setting the second straight line to pass through the second defining opening and pass through the first defining opening at the same time, the relative positional relationship between the first defining opening and the second defining opening can be adjusted, which is helpful to improve the isolation effect of the first defining opening and the second defining opening on the common layer in the light-emitting functional layer.

In some examples, as shown in FIG. 1, the light-emitting region 101 of the first sub-pixel 11 includes a first axis of symmetry S1, the light-emitting region 101 of the second sub-pixel 12 includes a second axis of symmetry S2, the area of a portion of the first defining opening 421 located at a first side of the first axis of symmetry S1 is not less than the area of a portion of the first defining opening 421 located at a second side of the first axis of symmetry S1, the area of a portion of the second defining opening 422 located at a first side of the second axis of symmetry S2 is not less than the area of a portion of the second defining opening 422 located at a second side of the second axis of symmetry S2, and an extending direction of the first axis of symmetry S1 intersects with an extending direction of the second axis of symmetry S2. Taking the first axis of symmetry of the first sub-pixel and the second axis of symmetry of the second sub-pixel as boundaries, the areas of the portions of the defining openings located at both sides of the axis of symmetry are set, which is helpful to reduce the crosstalk between the first sub-pixel and the second sub-pixel adjacent to each other without affecting the luminous display effect of each sub-pixel.

For example, as shown in FIG. 1, the first side of the first axis of symmetry S1 is located at the right side of the second side of the first axis of symmetry S1, the first side of the second axis of symmetry S2 is located at the right side of the second side of the second axis of symmetry S2, and the first side of the second axis of symmetry S2 is located at the upper side of the second side of the second axis of symmetry S2.

For example, as shown in FIG. 1, the first axis of symmetry S1 can be an axis of symmetry passing through corners of the light-emitting region 101 of the first sub-pixel 11, and the second axis of symmetry S2 can be the long axis or the short axis of the elliptical light-emitting region 101 of the second sub-pixel 12. For example, the first axis of symmetry S1 can extend along the first direction or along the second direction.

For example, as shown in FIG. 1, the first defining opening 421 is only located at the first side of the first axis of symmetry S1, and at least 60% of the second defining opening 422 is located at the first side of the second axis of symmetry S2. For example, the first defining opening 421 is completely located at the first side of the first axis of symmetry S1. For example, at least 65% of the second defining opening 422 is located at the first side of the second axis of symmetry S2. For example, at least 70% of the second defining opening 422 is located at the first side of the second axis of symmetry S2. For example, at least 75% of the second defining opening 422 is located at the first side of the second axis of symmetry S2. For example, at least 80% of the second defining opening 422 is located at the first side of the second axis of symmetry S2. For example, at least 85% of the second defining opening 422 is located at the first side of the second axis of symmetry S2. For example, at least 90% of the second defining opening 422 is located at the first side of the second axis of symmetry S2.

In some examples, as shown in FIG. 1, any straight line extending along a second direction passes through the second defining opening 422 surrounding the same second sub-pixel 12 at most once, and the second direction intersects with the first direction. For example, any of the above straight lines may only pass through the second defining opening 422 located at the right side of the light-emitting region 101 of the same second sub-pixel 12 once or may not pass through the second defining opening 422 surrounding the second sub-pixel 12.

By setting the relative positional relationship between the light-emitting region of the second sub-pixel and the second defining opening, it is helpful to increase the width of the communication channel between other sub-pixel close to the second sub-pixel in the second direction and the second electrode.

In some examples, as shown in FIG. 1, the first defining opening 421 surrounding the same first sub-pixel 11 is a continuous opening or a discontinuous opening, and the second defining opening 422 surrounding the same second sub-pixel 12 is a continuous opening or a discontinuous opening. For example, in an example of the embodiment of the present disclosure as shown in FIG. 1, the first defining opening 421 surrounding the same first sub-pixel 11 is a continuous opening, and the second defining opening 422 surrounding the same second sub-pixel 12 is a continuous opening. By setting the first defining opening and the second defining opening as continuous openings, it is helpful to isolate the common layer in the light-emitting functional layers of two adjacent sub-pixels which are prone to crosstalk, so as to reduce crosstalk.

In some examples, as shown in FIG. 1, the light-emitting region 101 of the first sub-pixel 11 includes four curved sides and four corners connecting the four curved sides, the four curved sides are all bent towards the center of the light-emitting region 101 of the first sub-pixel, the first defining opening 421 surrounds at most two curved sides of the four curved sides and at most one corner of the four corners, and the first defining opening 421extends along the extending direction of the edge of the light-emitting region 101 of the first sub-pixel 11. For example, four corners of the light-emitting region 101 of the first sub-pixel 11 can be rounded corners. For example, the first defining opening 421 surrounds two curved sides of the four curved sides and the included angle between the two curved sides. The first defining opening as mentioned above can surround a part of at least one curved side, and for example, a part of at least one curved side is opposite to the first defining opening. For example, one corner of the light-emitting region 101 of the first sub-pixel 11 is completely surrounded by the first defining opening.

For example, as shown in FIG. 1, distances between the first defining opening 421 and at least two corners of the light-emitting region 101 of the first sub-pixel 11 surrounded by the first defining opening are different. For example, the light-emitting region 101 of the first sub-pixel 11 includes at least one first corner and a plurality of second corners, the first corner is a corner surrounded by the first defining opening 421, the second corner is a corner not surrounded by the first defining opening 421, and the distances between the first defining opening 421 and at least two second corners are different. By setting the distances between the first defining opening and different second corners to be different, it is helpful to adjust the position and area of the communication channel of the second electrode of the first sub-pixel.

In some examples, as shown in FIG. 1, the shape of the light-emitting region 101 of the second sub-pixel 12 includes an ellipse or a circle, and the second defining opening 422 extends along an extending direction of an edge of the light-emitting region 101 of the second sub-pixel 12. For example, the shape of the light-emitting region 101 of the second sub-pixel 12 is an ellipse, an extension line of the long axis of the ellipse passes through the second defining opening 422 only once, and an extension line of the short axis of the ellipse passes through the second defining opening 422 once. By setting the relative positional relationship among the long and short axes of the ellipse and the second defining opening, it is helpful to isolate the common layer in the light-emitting functional layers of two adjacent sub-pixels which are prone to crosstalk, and at the same time, increase the area of the communication channel of the second electrode as much as possible.

For example, as shown in FIG. 1, the shape of the light-emitting region of the third sub-pixel 13 includes a quadrangle, such as a rounded quadrangle.

In some examples, as shown in FIG. 1, the number of first sub-pixels 11 is plural, the number of second sub-pixels 12 is plural, and a plurality of first sub-pixels 11 and a plurality of second sub-pixels 12 include a first sub-pixel 11 and a second sub-pixel 12 adjacent to each other. For example, the plurality of first sub-pixels 11 and the plurality of second sub-pixels 12 include a first sub-pixel 11 and a second sub-pixel 12 adjacent to each other in the V direction.

In some examples, as shown in FIG. 1, one of the first defining opening 421 and the second defining opening 422 is arranged between the first sub-pixel 11 and the second sub-pixel 12 adjacent to each other, and the first defining opening 421 between the first sub-pixel 11 and the second sub-pixel 12 adjacent to each other is closer to the edge of the light-emitting region 101 of the first sub-pixel 11, or the second defining opening 422 between the first sub-pixel 11 and the second sub-pixel 12 adjacent to each other is closer to the edge of the light-emitting region 101 of the second sub-pixel 12. By setting the distance between the first defining opening, which is located between the first sub-pixel and the second sub-pixel, and the first sub-pixel, as well as the distance between the second defining opening, which is located between the first sub-pixel and the second sub-pixel, and the second sub-pixel, the position of the light-emitting functional layer isolated by the first defining opening and the position of the light-emitting functional layer isolated by the second defining opening can be adjusted, which is helpful to reduce the crosstalk between the first sub-pixel and the second sub-pixel adjacent to each other.

In some examples, as shown in FIG. 1, the plurality of sub-pixels 10 further include a third sub-pixel 13, the plurality of second openings 420 further include a third defining opening 423, and the third defining opening 423 exposes a portion of the defining structure 200 surrounding the light-emitting region 101 of the third sub-pixel 13.

In some examples, as shown in FIG. 1, a straight line passing through the center of the light-emitting region 101 of the third sub-pixel 13 and extending along the first direction is a third straight line L3, the area of a portion of the third defining opening 423 located at the first side L31 of the third straight line L3 is not less than the area of a portion of the third defining opening 423 located at the second side L32 of the third straight line L3, and the relative positional relationship between the first side L31 and the second side L32 of the third straight line L3 is the same as the relative positional relationship between the first side L11 and the second side L12 of the first straight line L1.

For example, FIG. 1 illustratively shows that the first straight line L1 and the third straight line L3 are the same straight line, but it is not limited thereto, and the first straight line L1 and the third straight line L3 can be separated from each other.

For example, as shown in FIG. 1, the circumference of the portion of the third defining opening 423 located at the first side L31 of the third straight line L3 is not less than the circumference of the portion of the third defining opening 423 located at the second side L32 of the third straight line L3.

For example, as shown in FIG. 1, at least 60% of the third defining opening 423 is located at the first side L31 of the third straight line L3. For example, at least 65% of the third defining opening 423 is located at the first side L31 of the third straight line L3. For example, at least 70% of the third defining opening 423 is located at the first side L31 of the third straight line L3. For example, at least 75% of the third defining opening 423 is located at the first side L31 of the third straight line L3. For example, at least 80% of the third defining opening 423 is located at the first side L31 of the third straight line L3. For example, at least 85% of the third defining opening 423 is located at the first side L31 of the third straight line L3. For example, at least 90% of the third defining opening 423 is located at the first side L31 of the third straight line L3. For example, at least 95% of the third defining opening 423 is located at the first side L31 of the third straight line L3. For example, the third defining opening 423 is completely located at the first side L31 of the third straight line L3.

By setting the positional relationship between the first defining opening and the first straight line, the positional relationship between the second defining opening and the second straight line, and the positional relationship between the third defining opening and the third straight line, the width of the communication channel, between adjacent sub-pixels, of the second electrode shared by different color sub-pixels, can be increased, so that the conductive effect of the second electrode is improved to avoid high power consumption and brightness uniformity issues of the display substrate.

In some examples, as shown in FIG. 1, the light-emitting region 101 of the third sub-pixel 13 includes a third axis of symmetry S3, and the area of a portion of the third defining opening 423 located at a first side of the third axis of symmetry S3 is not less than the area of a portion of the third defining opening 423 located at a second side of the third axis of symmetry S3.

For example, as shown in FIG. 1, the relative positional relationship between the first side and the second side of the first axis of symmetry S1 is the same as the relative positional relationship between the first side and the second side of the third axis of symmetry S3. For example, the first side of the third axis of symmetry S3 is located at the right side of the second side of the third axis of symmetry S3.

For example, as shown in FIG. 1, the third axis of symmetry S3 can be an axis of symmetry passing through corners of the light-emitting region 101 of the third sub-pixel 13. For example, the third axis of symmetry S3 can extend along the first direction or along the second direction. For example, the first axis of symmetry S1 can be parallel to or intersect with the third axis of symmetry S3. For example, the third axis of symmetry S3 intersects with the second axis of symmetry S2.

For example, as shown in FIG. 1, the third defining opening 423 is only located at the first side of the third axis of symmetry S3.

For example, as shown in FIG. 1, the first axis of symmetry S1 can coincide with the first straight line L1, but it is not limited thereto, and the first axis of symmetry can also intersect with the first straight line. For example, the second axis of symmetry S2 intersects with the second straight line L2. For example, the third axis of symmetry S3 can coincide with the third straight line L3, but it is not limited thereto, and the third axis of symmetry may can also intersect with the third straight line.

In some examples, as shown in FIG. 1, the first sub-pixel 11 is a blue sub-pixel, one of the second sub-pixel 12 and the third sub-pixel 13 is a red sub-pixel, and the other of the second sub-pixel 12 and the third sub-pixel 13 is a green sub-pixel. FIGS. 1 and 2 illustratively show that the second sub-pixel is a green sub-pixel and the third sub-pixel is a red sub-pixel, but it is not limited thereto. The second sub-pixel can be a green sub-pixel and the third sub-pixel can be a red sub-pixel.

For example, as shown in FIG. 1, the turn-on voltage of the first sub-pixel 11 is 0.1V to 5V higher than the turn-on voltage of the second sub-pixel 12. For example, the turn-on voltage of the first sub-pixel 11 is 0.1V to 5V higher than the turn-on voltage of the third sub-pixel 13. For example, the turn-on voltage can refer to the voltage applied to the element when the luminous brightness is 1cd/m², and it can also be called the luminous threshold voltage.

For example, the turn-on voltage of the first sub-pixel 11 is 0.5V to 4.5V higher than the turn-on voltage of the second sub-pixel 12. For example, the turn-on voltage of the first sub-pixel 11 is 1V to 4V higher than the turn-on voltage of the second sub-pixel 12. For example, the turn-on voltage of the first sub-pixel 11 is 1.5V to 3.5V higher than the turn-on voltage of the second sub-pixel 12. For example, the turn-on voltage of the first sub-pixel 11 is 2V to 3V higher than the turn-on voltage of the second sub-pixel 12. For example, the turn-on voltage of the first sub-pixel 11 is 0.5V to 4.5V higher than the turn-on voltage of the third sub-pixel 13. For example, the turn-on voltage of the first sub-pixel 11 is 1V to 4V higher than the turn-on voltage of the third sub-pixel 13. For example, the turn-on voltage of the first sub-pixel 11 is 1.5V to 3.5V higher than the turn-on voltage of the third sub-pixel 13. For example, the turn-on voltage of the first sub-pixel 11 is 2V to 3V higher than the turn-on voltage of the third sub-pixel 13. For example, the turn-on voltage of the first sub-pixel 11 is 1.5V higher than the turn-on voltage of the second sub-pixel 12. For example, the turn-on voltage of the first sub-pixel 11 is 1.5V higher than the turn-on voltage of the third sub-pixel 13.

For example, the power consumption of the first sub-pixel 11 is greater than the power consumption of the second sub-pixel 12, and is greater than the power consumption of the third sub-pixel 13.

For example, as shown in FIG. 1, the area of the light-emitting region of one first sub-pixel 11 is greater than the area of the light-emitting region of one second sub-pixel 12, and the area of the light-emitting region of one first sub-pixel 11 is greater than the area of the light-emitting region of one third sub-pixel 13. For example, the area of the light-emitting region of one second sub-pixel 12 is less than the area of the light-emitting region of one third sub-pixel 13. For example, the luminous efficiency of the first sub-pixel 11 is less than the luminous efficiency of the second sub-pixel 12, and is less than the luminous efficiency of the third sub-pixel 13.

The luminous efficiency of a sub-pixel refers to the intensity of light emitted by the light-emitting element of the sub-pixel under the same electrical signal condition. Assuming that the light intensity is high, the luminous efficiency is considered to be high. For example, the same electrical signal condition means that the voltage written into the data line is the same. For example, the same electrical signal condition means that the current flowing through the light-emitting element is the same. For example, the luminous efficiency of a sub-pixel refers to the current density flowing through a light-emitting element under the same electrical signal condition.

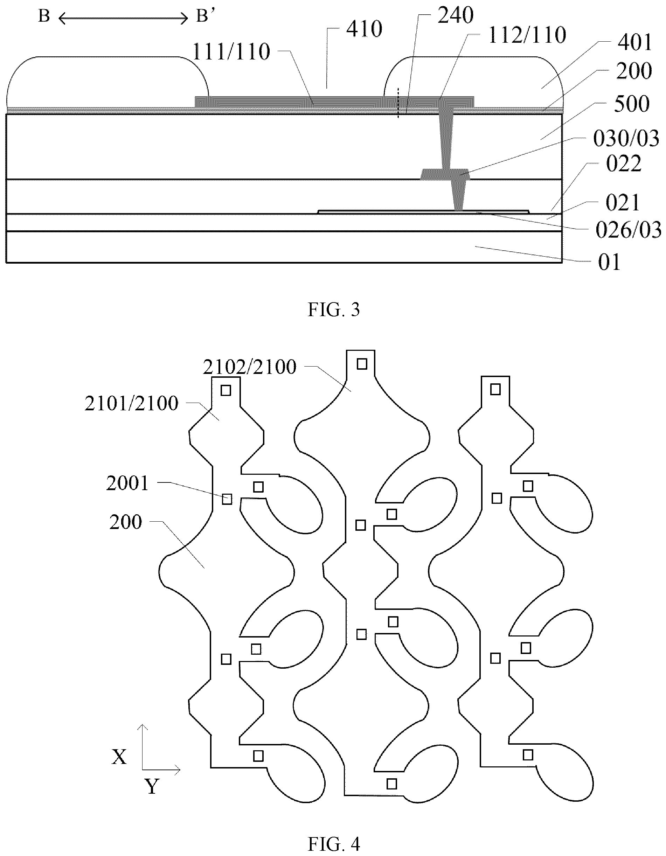

FIG. 3 is a partial cross-sectional structural view taken along line BB' shown in FIG. 1. FIG. 4 is a schematic diagram of a defining structure in the display substrate shown in FIG. 1.

In some examples, as shown in FIGS. 1 and 3, each sub-pixel in at least part of the sub-pixels further includes a pixel circuit 03. The first electrode 110 includes a main electrode 111 and a connection electrode 112, the connection electrode 112 does not overlap with the light-emitting region 101 in the direction perpendicular to the base substrate 01, and the connection electrode 112 is electrically connected with the pixel circuit 03. For example, as shown in FIGS. 3 and 4, the defining structure 200 includes a connection via hole 2001, and the connection electrode 112 of the sub-pixel is electrically connected with the pixel circuit 03 through the connection via hole 2001.

In some examples, as shown in FIGS. 1 and 4, in the first sub-pixel 11, the included angle between a connection line from the connection via hole 2001 to the center of the light-emitting region 101 and the first straight line L1 is a first included angle; in the second sub-pixel 12, the included angle between a connection line from the connection via hole 2001 to the center of the light-emitting region 101 and the first straight line L1 is a second included angle; and the second included angle is greater than the first included angle. For example, the first included angle is not greater than 10 degrees. For example, the first included angle is not greater than 5 degrees. For example, the first included angle is not greater than 2 degrees. For example, the first included angle is not greater than 1 degree. For example, the first included angle is 0 degree. For example, the second included angle is greater than 10 degrees. For example, the second included angle is greater than 20 degrees.

In some examples, as shown in FIGS. 1 and 4, in the first sub-pixel 11, an extension line (which can be, for example, the first axis of symmetry S1) of the connection line of the connection via hole 2001 and the center of the light-emitting region 101 does not pass through the second opening 420 surrounding the first sub-pixel 11; and in the second sub-pixel 12, an extension line E2 of the connection line of the connection via hole 2001 and the center of the light-emitting region 101 passes through the second opening 420 surrounding the second sub-pixel 12.

For example, as shown in FIGS. 1 and 3, the main electrode 111 and the connection electrode 112 of the first electrode 110 can be an integrated structure, and an orthographic projection of the light-emitting region 101 on the base substrate 01 is completely within the orthographic projection of the main electrode 111 on the base substrate 01. For example, the shape of the main electrode 111 is substantially the same as the shape of the light-emitting region 101. For example, the connection electrode 112 can be electrically connected with the pixel circuit 03 through a via in the insulating layer 500.

For example, as shown in FIG. 3, the base substrate 01 is provided with a buffer layer and a shielding layer 021, an active layer 026 is provided on the buffer layer and a shielding layer 021, a gate insulating layer 022 is provided on the active layer 026, and a source-drain metal layer 030 is provided on the gate insulating layer 022, and the source-drain metal layer 030 is connected with the active layer 026 through a via located in the gate insulating layer 022. For example, the source-drain metal layer 030 is a metal layer electrically connected with the source region and the drain region of the active layer 026. For example, the pixel circuit 03 includes a plurality of transistors and at least one capacitor, and the source-drain metal layer 030 and the active layer 026 are the structures in the transistors. For example, the pixel circuit can have a structure of 7T1C, 8T1C, 2T1C, 3TIC or the like, without being limited in the embodiment of the present disclosure, and can be set according to the actual needs of the display substrate.

In some examples, as shown in FIG. 1, the defining structure 200 includes a first annular defining structure 210 surrounding the main electrode 111 of the first sub-pixel 11 and a second annular defining structure 220 surrounding the main electrode 111 of the second sub-pixel 12. For example, in the direction perpendicular to the base substrate, the first annular defining structure 210 does not overlap with the main electrode 111 of the first sub-pixel 11 substantially, and the second annular defining structure 220 does not overlap with the main electrode 111 of the second sub-pixel 12 substantially. For example, the first annular defining structure 210 can be a closed annular structure, and the first annular defining structure 210 overlaps with the connection electrode 112 of the first sub-pixel 11 in the direction perpendicular to the base substrate. For example, the first annular defining structure 210 can be a non-closed annular structure, and the first annular defining structure 210 does not overlap with the connection electrode 112 of the first sub-pixel 11 in the direction perpendicular to the base substrate. For example, the second annular defining structure 220 can be a closed annular structure, and the second annular defining structure 220 overlaps with the connection electrode 112 of the second sub-pixel 12 in the direction perpendicular to the base substrate. For example, the second annular defining structure 220 can be a non-closed annular structure, and the second annular defining structure 220 does not overlap with the connection electrode 112 of the second sub-pixel 12 in the direction perpendicular to the base substrate.

In some examples, as shown in FIG. 1, the defining structure 200 includes a third annular defining structure 230 surrounding the main electrode 111 of the third sub-pixel 13. For example, in the direction perpendicular to the base substrate, the third annular defining structure 230 does not overlap with the main electrode 111 of the third sub-pixel 13 substantially. For example, the third annular defining structure 230 can be a closed annular structure, and the third annular defining structure 230 overlaps with the connection electrode 112 of the third sub-pixel 13 in the direction perpendicular to the base substrate. For example, the third annular defining structure 230 can be a non-closed annular structure, and the third annular defining structure 230 does not overlap with the connection electrode 112 of the third sub-pixel 13 in the direction perpendicular to the base substrate.

In some examples, as shown in FIG. 1, the area of a portion of the first annular defining structure 210 not exposed by the first defining opening 421 is not less than the area of a portion of the first annular defining structure 210 exposed by the first defining opening 421. For example, the area of the portion of the first annular defining structure 210 not exposed by the first defining opening 421 is greater than the area of the portion of the first annular defining structure 210 exposed by the first defining opening 421.

For example, as shown in FIG. 1, the portion of the first annular defining structure 210 overlapped with the connection electrode 112 is not exposed by the first defining opening 421.

In some examples, as shown in FIG. 1, the area of a portion of the second annular defining structure 220 not exposed by the second defining opening 422 is not less than the area of a portion of the second annular defining structure 220 exposed by the second defining opening 422. For example, the area of the portion of the second annular defining structure 220 not exposed by the second defining opening 422 is greater than the area of the portion of the second annular defining structure 220 exposed by the second defining opening 422.

For example, as shown in FIG. 1, the portion of the second annular defining structure 220 overlapped with the connection electrode 112 is not exposed by the second defining opening 422.

In some examples, as shown in FIG. 1, the area of a portion of the third annular defining structure 230 not exposed by the third defining opening 423 is not less than the area of a portion of the third annular defining structure 230 exposed by the third defining opening 423. For example, the area of the portion of the third annular defining structure 230 not exposed by the third defining opening 423 is greater than the area of the portion of the third annular defining structure 230 exposed by the third defining opening 423.

For example, as shown in FIG. 1, the portion of the third annular defining structure 230 overlapped with the connection electrode 112 is not exposed by the third defining opening 423.

By setting the area relationship between the portion of the first annular defining structure exposed by the first defining opening and the portion of the first annular defining structure not exposed by the first defining opening, the area relationship between the portion of the second annular defining structure exposed by the second defining opening and the portion of the second annular defining structure not exposed by the second defining opening, and the area relationship between the portion of the third annular defining structure exposed by the third defining opening and the portion of the third annular defining structure not exposed by the third defining opening, it is helpful to improve the continuity and conductive effect of the communication channel of the second electrode.

In some examples, as shown in FIGS. 1 and 3, the defining structure 200 includes a defining connection structure 240 stacked with the connection electrode, and the second opening 420 extends to the edge of the defining connection structure 240 corresponding to the connection electrodes 112 of part of the sub-pixels. For example, in the direction perpendicular to the base substrate 01, the defining connection structure 240 does not overlap with the second opening 420. By setting the positions of the defining connection structure and the second opening, it can prevent the second opening from affecting the electrical connection between the connection electrode and the pixel circuit. In the case where the first annular defining structure, the second annular defining structure and the third annular defining structure are closed annular structures, the defining connection structure can be a portion of the closed annular defining structure; in the case where the first annular defining structure, the second annular defining structure and the third annular defining structure are non-closed annular structures, the defining connection structure and the non-closed annular defining structure can form an annular structure together.

For example, as shown in FIG. 1, the number of first sub-pixels 11 is plural, the number of second sub-pixels 12 is plural, the number of third sub-pixels 13 is plural, the first sub-pixels 11 and third sub-pixels 13 are alternately arranged along the first direction as a first sub-pixel group 10-1, the second sub-pixels 12 are arranged along the first direction as a second sub-pixel group 10-2, and the first sub-pixel group 10-1 and the second sub-pixel group 10-2 are alternately arrange along the second direction.

For example, as shown in FIG. 1, the first sub-pixels 11 and the third sub-pixels 13 are arranged alternately and at equal intervals along the first direction. The "interval" in "being arranged at equal intervals" described above refers to the distance between the centers of the light-emitting regions of the sub-pixels.

For example, as shown in FIGS. 1 and 4, in the direction perpendicular to the base substrate, portions of the defining structure 200 overlapped with at least two first openings 410 can be an integrated structure. For example, the defining structure 200 includes a plurality of extension defining structures 2100 arranged along the second direction, and the minimum distance between two adjacent extension defining structures 2100 is less than the minimum distance between two adjacent first openings 410 arranged along the second direction. For example, the plurality of extension defining structures 2100 include a first sub-extension defining structure 2101 and a second sub-extension defining structure 2102 alternately arranged along the second direction, and the shape of the first sub-extension defining structure 2101 is different from the shape of the second sub-extension defining structure 2102. By setting the defining structures corresponding to two columns of sub-pixels or two rows of sub-pixels into an integrated structure, it is helpful to prevent the defining structures from peeling.

Of course, the embodiment of the present disclosure is not limited thereto; the defining structure can also include a plurality of first extension defining structures arranged along the first direction and a plurality of second extending structures arranged along the second direction, and the plurality of first extension defining structures are connected with the plurality of second extension defining structures to form a mesh structure; or, the defining structure includes a plurality of defining blocks arranged at intervals, and each defining block overlaps with the first openings corresponding to two different color sub-pixels.

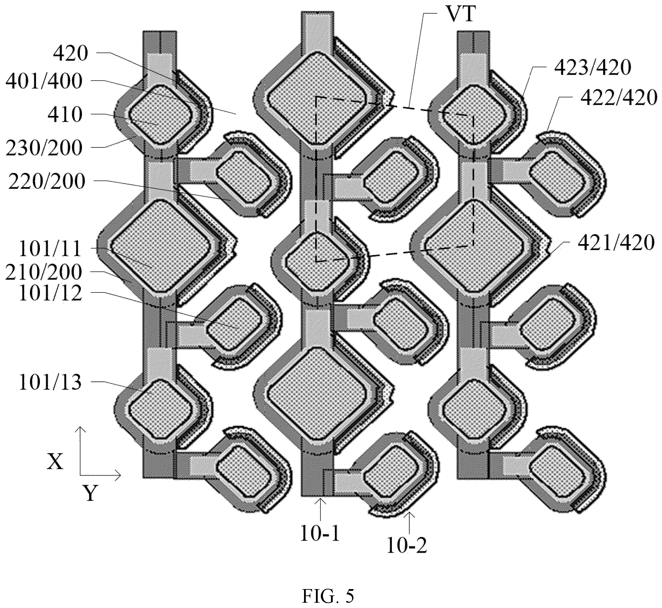

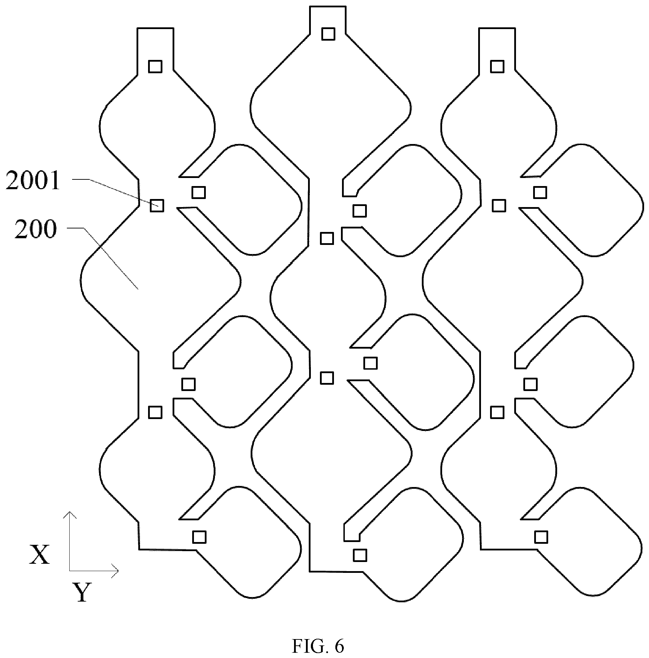

FIG. 5 is a partial structural view of a display substrate according to another example of an embodiment of the present disclosure. FIG. 6 is a schematic diagram of a defining structure in the display substrate shown in FIG. 5. The shape of the light-emitting region 101 of the first sub-pixel 11 in the display substrate shown in FIG. 5 is different from the shape of the light-emitting region 101 of the first sub-pixel 11 in the display substrate shown in FIG. 1, and the shape of the light-emitting region 101 of the second sub-pixel 12 in the display substrate shown in FIG. 5 is different from the shape of the light-emitting region 101 of the second sub-pixel 12 in the display substrate shown in FIG. 1. The features of the display substrate shown in FIG. 5, such as the defining structure, the pixel circuit and the first electrode and the light-emitting functional layer and the second electrode included in each sub-pixel, the positional relationship between the first opening and the light-emitting functional layer of the sub-pixel, the positional relationship between the first defining opening and the first straight line, the positional relationship between the second defining opening and the second straight line, the positional relationship between the third defining opening and the third straight line, and the relationship between the turn-on voltage of the first sub-pixel and the turn-on voltage of the second sub-pixel, etc., can be the same as those of the display substrate shown in FIG. 1.

In some examples, as shown in FIG. 5, the light-emitting region 101 of the first sub-pixel 11 includes four straight sides and four corners connecting the four straight sides, and the first defining opening 421 surrounds at most two straight sides of the four straight sides and at most one corner of the four corners. For example, the first defining opening 421 extends along the extending direction of the edge of the light-emitting region 101 of the first sub-pixel 11. For example, the four corners of the light-emitting region 101 of the first sub-pixel 11 can be rounded corners. For example, the first defining opening 421 surrounds two straight sides of the four straight sides and the included angle between the two straight sides.

For example, as shown in FIG. 5, the distances between the first defining opening 421 and at least two corners of the light-emitting region 101 of the first sub-pixel 11 surrounded by the first defining opening are different. For example, the light-emitting region 101 of the first sub-pixel 11 includes at least one first corner and a plurality of second corners, the first corner is a corner surrounded by the first defining opening 421, the second corner is a corner not surrounded by the first defining opening 421, and the distances between the first defining opening 421 and at least two second corners are different. By setting the distances between the first defining opening and different second corners to be different, it is helpful to adjust the position and area of the communication channel of the second electrode of the first sub-pixel.

In some examples, as shown in FIG. 5, the light-emitting region 101 of the second sub-pixel 12 includes four straight sides and four corners connecting the four straight sides, and the second defining opening 422 surrounds at least two straight sides of the four straight sides and at least two corners of the four corners. For example, the shape of the second defining opening 422 is substantially the same as the shape of the portion of the light-emitting region 101 of the second sub-pixel 12 that is surrounded. For example, the shape of the light-emitting region 101 of the second sub-pixel 12 can be a rounded quadrangle. For example, the light-emitting region 101 of the second sub-pixel 12 includes two long sides and two short sides, and an axis of symmetry parallel to the long side and an axis of symmetry parallel to the short side, and both extension lines of these two axes of symmetry pass through the second defining opening 422 only once. By setting the relative positional relationship between the two axes of symmetry of the light-emitting region of the second sub-pixel and the second defining opening, it is helpful to isolate the common layer in the light-emitting functional layers of two adjacent sub-pixels which are prone to crosstalk, and at the same time, increase the area of the communication channel of the second electrode as much as possible.

For example, as shown in FIG. 5, the shape of the light-emitting region 101 of the third sub-pixel 13 includes a quadrangle, such as a rounded quadrangle.

In some examples, as shown in FIG. 5, the centers of a certain first sub-pixel 11 and a certain third sub-pixel 13 adjacent to each other in the same first sub-pixel group 10-1, and the centers of one first sub-pixel 11 and one third sub-pixel 13, which are located in an adjacent first sub-pixel group 10-1 and are respectively adjacent to the certain first sub-pixel 11 and the certain third sub-pixel 13 adjacent to each other in the second direction, are taken as four vertices of a virtual trapezoid VT, and one second sub-pixel 12 is arranged in the virtual trapezoid VT. For example, the plurality of sub-pixels are arranged in a "tripod (a type of ancient bronze vessel) -shaped pixel arrangement".

For example, as shown in FIG. 5, the center of the first sub-pixel 11 as mentioned above, the center of the second sub-pixel 12 as mentioned above and the center of the third sub-pixel 13 as mentioned above respectively refer to the geometric center of the light-emitting region of each sub-pixel, or a region with a small radius centered on the geometric center of the light-emitting region of each sub-pixel.

For example, as shown in FIG. 5, the virtual trapezoid VT can be an isosceles trapezoid.

For example, as shown in FIG. 5, the first sub-pixels 11 and the third sub-pixels 13 arranged long the first direction are arranged at unequal intervals. For example, among the first sub-pixels 11 and the third sub-pixels 13 arranged long the first direction, the distances between the third sub-pixel 13, which is located between two first sub-pixels, and the two first sub-pixels 11 are different; for example, the distance between the center of the third sub-pixel 13 and the center of the light-emitting region of an adjacent first sub-pixel 11 located at the upper side of the third sub-pixel 13 is a first distance, the distance between the center of the third sub-pixel 13 and the center of the light-emitting region of an adjacent first sub-pixel 11 located at the lower side of the third sub-pixel 13 is a second distance, the first distance is greater than the second distance, and the first distance and the second distance are alternately arranged.

The defining structure shown in FIG. 6 is different from the defining structure shown in FIG. 4 in that the shapes of part of the defining structures corresponding to the first sub-pixels are different, and the shapes of part of the defining structures corresponding to the second sub-pixels are different. Other features of the defining structure shown in FIG. 6 are the same as those of the defining structure shown in FIG. 4, and details will not be repeated here.

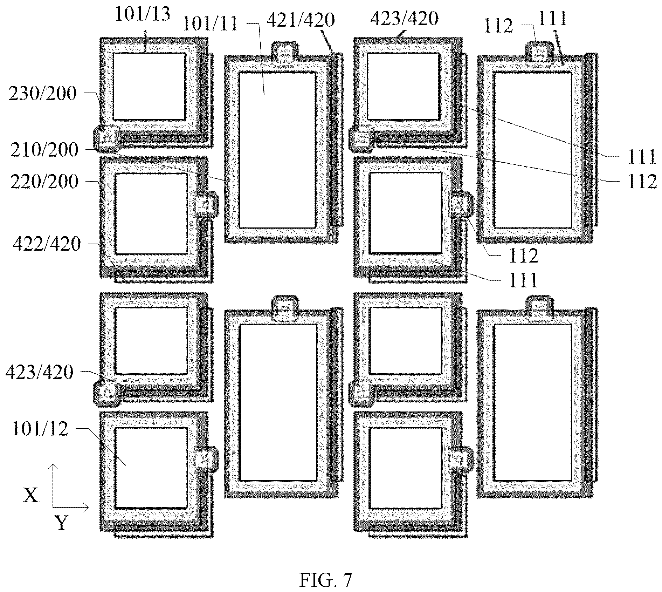

FIGS. 7-10 are partial structural views of display substrates according to different examples of an embodiment of the present disclosure. The display substrates in the examples shown in FIGS. 7-10 differ from the display substrate shown in FIG. 1 in the shapes of the sub-pixels and the distribution of the sub-pixels. The features of the display substrates shown in FIGS. 7-10, such as the defining structure, the pixel circuit and the first electrode and the light-emitting functional layer and the second electrode included in each sub-pixel, the positional relationship between the first opening and the light-emitting functional layer of the sub-pixel, the positional relationship between the first defining opening and the first straight line, the positional relationship between the second defining opening and the second straight line, the positional relationship between the third defining opening and the third straight line, and the relationship between the turn-on voltage of the first sub-pixel and the turn-on voltage of the second sub-pixel, etc., can be the same as those of the display substrate shown in FIG. 1.

In some examples, as shown in FIGS. 7-10, the plurality of sub-pixels include a plurality of pixel units 10-3 arrayed along a first direction and a second direction, each pixel unit 10-3 includes one first sub-pixel 11, one second sub-pixel 12 and one third sub-pixel 13, and the second direction intersects with the first direction. For example, the shape of the light-emitting region 101 of the first sub-pixel 11, the shape of the light-emitting region 101 of the second sub-pixel 12 and the shape of the light-emitting region 101 of the third sub-pixel 13 are all rectangular.

For example, as shown in FIGS. 7-10, the plurality of sub-pixels include a third pixel group and a fourth pixel group alternately arranged along the second direction, the third pixel group includes second sub-pixels 12 and third sub-pixels 13 alternately arranged along the first direction, and the fourth pixel group includes a plurality of first sub-pixels 11 arranged along the first direction. For example, the center connection line of the light-emitting regions 101 of two adjacent first sub-pixels 11 arranged along the X direction does not pass through the second opening 420.

For example, as shown in FIGS. 7-10, the area of the light-emitting region 101 of the first sub-pixel 11 is greater than the area of the light-emitting region 101 of the second sub-pixel 12, and the area of the light-emitting region 101 of the first sub-pixel 11 is greater than the area of the light-emitting region 101 of the third sub-pixel 13. For example, the area of the light-emitting region 101 of the second sub-pixel 12 is greater than the area of the light-emitting region 101 of the third sub-pixel 13. For example, the first sub-pixel 11 is a blue sub-pixel, the second sub-pixel 12 is a green sub-pixel, and the third sub-pixel 13 is a red sub-pixel. For example, the pixel arrangement shown in FIGS. 7 to 10 can be a real RGB pixel arrangement.

In some examples, as shown in FIGS. 7-10, in each pixel unit 10-3, the second sub-pixel 12 and the third sub-pixel 13 are alternately arranged along the first direction, and the first sub-pixel 11 and the third sub-pixel 13 are alternately arranged along the second direction. For example, the first sub-pixel 11 and the second sub-pixel 12 are arranged along the second direction.

For example, as shown in FIGS. 7-10, the distance between the light-emitting regions 101 of two first sub-pixels 11 adjacent to each other in the first direction is greater than the distance between the light-emitting regions 101 of the second sub-pixel 12 and the third sub-pixel 13 adjacent to each other in the first direction. Therefore, the distance between the two first sub-pixels is large, and the color thereof is the same; even if crosstalk therebetween occurs, the influence on the image quality is small. By not setting a defining structure between two adjacent sub-pixels of the same color, the size of the charge transmission channel of the second electrode between the light-emitting regions of the two first sub-pixels can be increased, so as to reduce the influence of cross-voltage between sub-pixels of different colors as much as possible and reduce the influence on the uniformity of image quality.

In some examples, as shown in FIGS. 7-10, in the first sub-pixel 11, the connection electrode 112 is located at one side of the main electrode 111 in the first direction. For example, in the first sub-pixel 11, the connection electrode 112 is located at the upper side of the main electrode 111. However, it is not limited thereto, and in the first sub-pixel, the connection electrodes can also be located at the lower side of the main electrode.

In some examples, as shown in FIGS. 7-10, in the second sub-pixel 12, the connection electrode 112 is located at one side of the main electrode 111 in the second direction. For example, in the second sub-pixel 12, the connection electrode 112 is located at the right side of the main electrode 111. However, it is not limited thereto, and in the second sub-pixel, the connection electrodes can also be located at the left side of the main electrode.

In some examples, as shown in FIGS. 7-10, in the third sub-pixel 13, the connection electrode 112 is located at one side of the main electrode 111 in the first direction. For example, in the third sub-pixel 13, the connection electrode 112 is located at the lower left of the main electrode 111. However, it is not limited thereto, and in the third sub-pixel, the connection electrodes can also be located at the lower right of the main electrode.

By setting the positional relationship between the main electrode and the connection electrode in each sub-pixel, the distance between adjacent sub-pixels can be reduced and the pixels per inch can be improved.

For example, as shown in FIGS. 7-10, the portion of the second opening 420 surrounding the light-emitting region 101 of at least one sub-pixel can extend to the edge of the defining structure 200 stacked with the connection electrode 112.

In some examples, as shown in FIGS. 7-10, the light-emitting region 101 of the first sub-pixel 11 includes four straight sides and four corners connecting the four straight sides, and the first defining opening 421 surrounds at least one straight side of the four straight sides and at most one corner of the four corners.

For example, as shown in FIG. 7, the first defining opening 421 extends along the first direction, and the length of the first defining opening 421 is less than the size of the first annular defining structure 210 in the first direction. For example, the length of the portion of the second defining opening 422 extending along the first direction is less than the size of the second annular defining structure 220 in the first direction. For example, the length of the portion of the third defining opening 423 extending along the first direction is less than the size of the third annular defining structure 230 in the first direction.

For example, as shown in FIG. 7, the length of the portion of the second defining opening 422 extending long the second direction is less than the size of the second annular defining structure 220 in the second direction. For example, the length of the portion of the third defining opening 423 extending along the second direction is less than the size of the third annular defining structure 230 in the second direction.

By setting the size of the second opening smaller in both the first direction and the second direction, it is helpful to reduce the crosstalk between adjacent sub-pixels and ensure that the conductive channel of the second electrode has a larger size as much as possible.

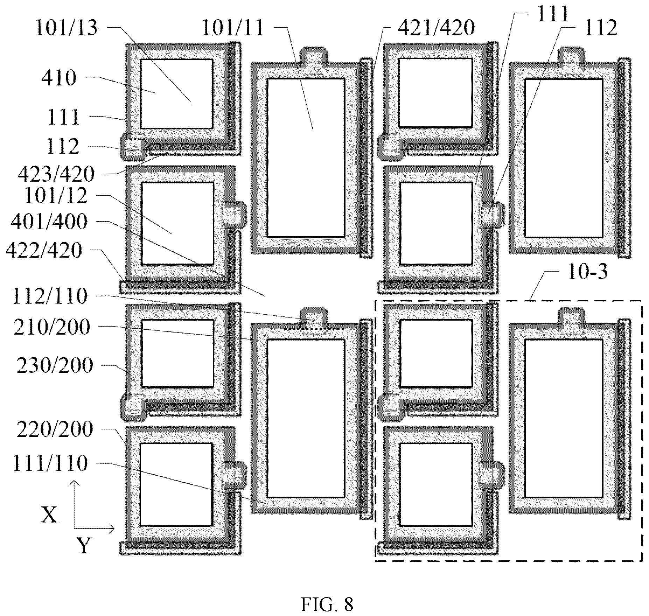

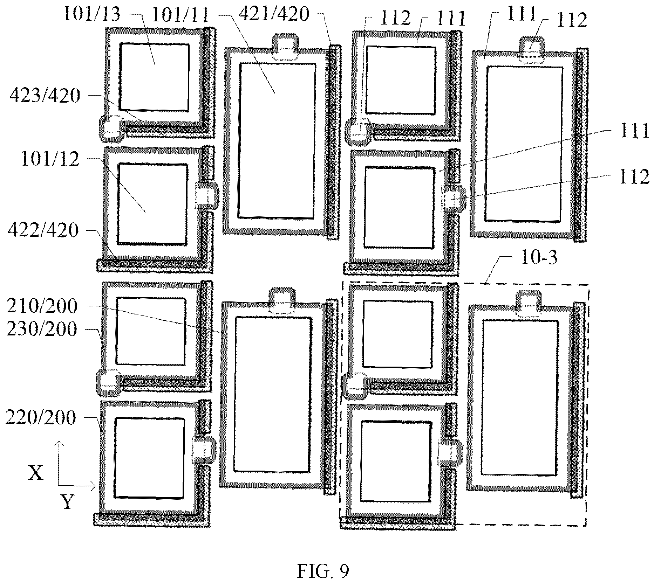

For example, as shown in FIGS. 8 and 9, the first defining opening 421 extends along the first direction. For example, the length of the first defining opening 421 can be greater than the size of the first annular defining structure 210, which is exposed by the first defining opening 421, in the first direction.

For example, as shown in FIGS. 8 and 9, the first defining opening 421 can be located only at one side of the light-emitting region 101 of the first sub-pixel 11 in the second direction.

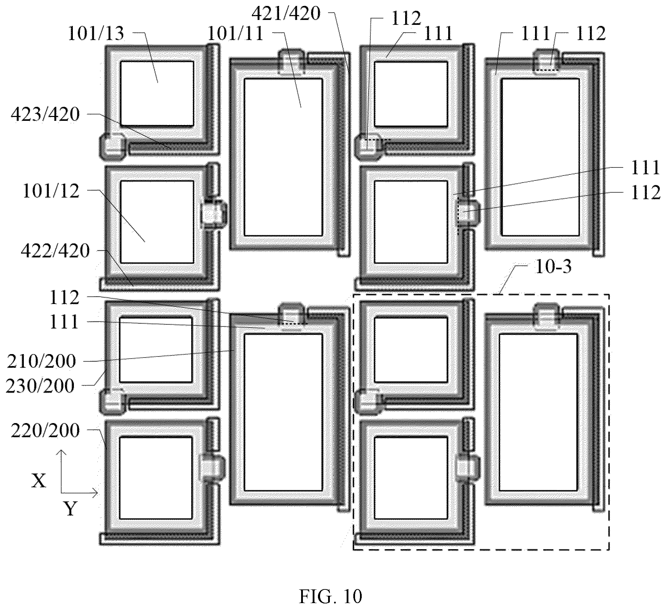

For example, as shown in FIGS. 9 and 10, the first defining opening 421 surrounding the same first sub-pixel 11 is a continuous opening, and the second defining opening 422 surrounding the same second sub-pixel 12 is a discontinuous opening. Of course, the embodiment of the present disclosure is not limited thereto, and the first defining opening surrounding the same first sub-pixel can also be a discontinuous opening.

For example, as shown in FIG. 10, the first defining opening 421 includes a portion extending along the first direction and a portion extending along the second direction; the length of the portion of the first defining opening 421 extending along the first direction can be greater than the size of the first annular defining structure 210, which is exposed by the first defining opening 421, in the first direction; and the length of the portion of the first defining opening 421 extending along the second direction is less than the length of the first annular defining structure 210 in the second direction. For example, the portion of the first defining opening 421 extending along the second direction is located at one side of the connection electrode 112 of the first sub-pixel 11.

In some examples, as shown in FIGS. 7-10, the light-emitting region 101 of the second sub-pixel 12 includes four straight sides and four corners connecting the four straight sides, and the second defining opening 422 surrounds at least one straight side of the four straight sides and at most one corner of the four corners.

For example, as shown in FIG. 8, the second defining opening 422 surrounds two sides of the light-emitting region 101 of the second sub-pixel 12 and the corner formed by connecting the two sides. For example, the second defining opening 422 includes a portion extending along the first direction and a portion extending along the second direction. For example, the length of the portion of the second defining opening 422 extending along the second direction can be greater than the size of the second annular defining structure 220 in the second direction. For example, the length of the portion of the second defining opening 422 extending along the first direction is less than the size of the second annular defining structure 220 in the first direction. For example, the portion of the second defining opening 422 extending along the first direction extends to the edge of the defining structure 200 stacked with the connection electrode 112.

For example, as shown in FIG. 8, the portion of the second defining opening 422 extending along the first direction is located at one side of the connection electrode 112, so as to increase the area of the communication channel of the second electrode and improve the conductive effect of the second electrode.

For example, as shown in FIGS. 9 and 10, the portion of the second defining opening 422 extending along the first direction is located at both sides of the connection electrode 112, which is helpful to reduce the crosstalk between the first sub-pixel and the second sub-pixel.

For example, as shown in FIGS. 7-10, the light-emitting region 101 of the third sub-pixel 13 includes four straight sides and four corners connecting the four straight sides, and the third defining opening 423 surrounds at least one straight side of the four straight sides and at most one corner of the four corners.

For example, as shown in FIGS. 7-10, the third defining opening 423 surrounds two sides of the light-emitting region 101 of the third sub-pixel 13 and the corner formed by connecting the two sides. For example, the third defining opening 423 includes a portion extending along the first direction and a portion extending along the second direction. For example, the length of the portion of the third defining opening 423 extending along the first direction can be greater than the size of the third annular defining structure 230 in the first direction. For example, the length of the portion of the third defining opening 423 extending along the second direction is less than the size of the third annular defining structure 230 in the second direction. For example, the portion of the third defining opening 423 extending along the second direction extends to the edge of the defining structure 200 stacked with the connection electrode 112.

For example, as shown in FIGS. 7-10, the third defining opening 423 between the third sub-pixel 13 and the first sub-pixel 11 is closer to the edge of the light-emitting region 101 of the third sub-pixel 13, and an orthographic projection of an edge of the light-emitting region 101 of the third sub-pixel 13 close to the first sub-pixel 11 on a straight line along the extending direction of the edge is completely located in the third defining opening 423. For example, the first defining opening 421 between the third sub-pixel 13 and the first sub-pixel 11 is closer to the edge of the light-emitting region 101 of the first sub-pixel 11, and the orthographic projection of an edge of the light-emitting region 101 of the first sub-pixel 11 close to the third sub-pixel 13 on a straight line along the extending direction of the edge is completely located in the first defining opening 421.

The third sub-pixel is a red sub-pixel. Because the red sub-pixel is easy to light when it should not be, by setting a longer first defining structure or a longer third defining structure between the first sub-pixel and the third sub-pixel, the size of the conductive channel of the second electrode between the first sub-pixel and the third sub-pixel is set to be smaller, which is helpful to prevent the red sub-pixel from crosstalk to the first sub-pixel, e.g., the blue sub-pixel.

For example, as shown in FIGS. 7-10, the axis of symmetry of the light-emitting region 101 of the first sub-pixel 11 can extend along the first direction. For example, the axis of symmetry of the light-emitting region 101 of the second sub-pixel 12 can extend along the first direction. For example, the axis of symmetry of the light-emitting region 101 of the third sub-pixel 13 can extend along the first direction. For example, the axis of symmetry of the light-emitting region 101 of the second sub-pixel 12 extending along the first direction passes through the second defining opening 422. For example, the axis of symmetry of the light-emitting region 101 of the third sub-pixel 13 extending along the first direction passes through the third defining opening 423.

For example, as shown in FIGS. 7-10, the axis of symmetry of the light-emitting region 101 of the first sub-pixel 11 can extend along the second direction. For example, the axis of symmetry of the light-emitting region 101 of the second sub-pixel 12 can extend along the second direction. For example, the axis of symmetry of the light-emitting region 101 of the third sub-pixel 13 can extend along the second direction. For example, the axis of symmetry of the light-emitting region 101 of the first sub-pixel 11 extending along the second direction passes through the first defining opening 421. For example, the axis of symmetry of the light-emitting region 101 of the second sub-pixel 12 extending along the second direction does not pass through the second defining opening 422. For example, the axis of symmetry of the light-emitting region 101 of the third sub-pixel 13 extending along the second direction passes through the third defining opening 423.

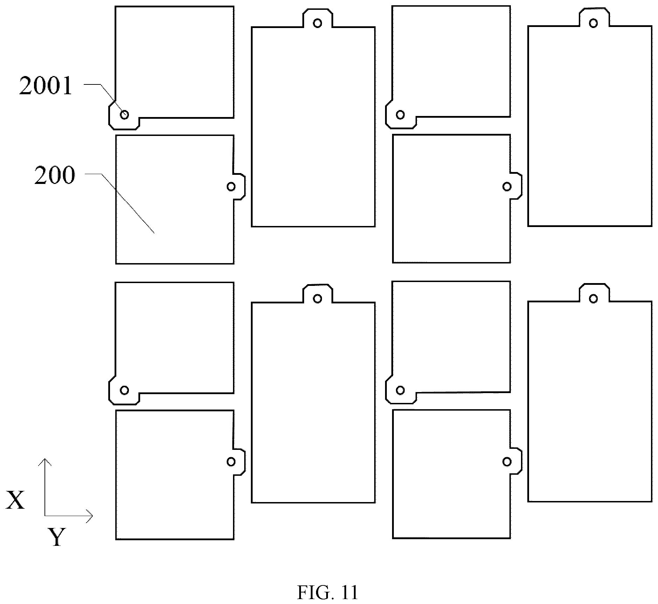

FIGS. 11-13 are schematic diagrams of a defining structure in the display substrate shown in FIG. 7 according to different examples.

For example, as shown in FIG. 11, the defining structures 200 corresponding to different sub-pixels can be independently arranged. For example, the two defining structures 200 corresponding to the first sub-pixel and the second sub-pixel adjacent to each other are spaced apart from each other and independently arranged. For example, the two defining structures 200 corresponding to the first sub-pixel and the third sub-pixel adjacent to each other are spaced apart from each other and independently arranged. For example, the two defining structures 200 corresponding to the second sub-pixel and the third sub-pixel adjacent to each other are spaced apart from each other and independently arranged. The "being independently arranged" described above means that the two structures are not connected. For example, each independent part of the defining structures 200 is provided with a connection via hole 2001, so as to realize the electrical connection between the second electrode of the sub-pixel and a corresponding pixel circuit.

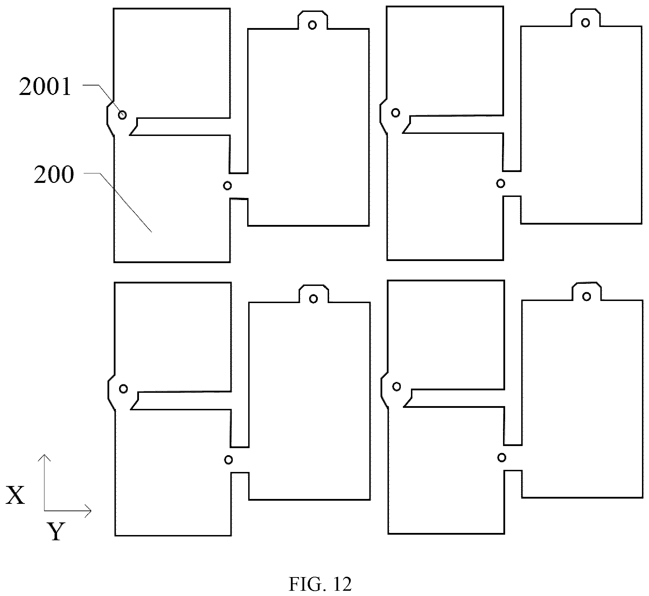

For example, as shown in FIG. 12, the defining structures 200 corresponding to three sub-pixels in each pixel unit can be an integrated structure, and the defining structures corresponding to adjacent pixel units are spaced apart from each other and independently arranged.

For example, as shown in FIG. 12, a connection portion of the defining structure 200 corresponding to the same pixel unit is located in the vicinity of the connection via hole 2001. For example, the connection portion of the defining structure 200 corresponding to the same pixel unit overlaps with the connection electrode of the sub-pixel.

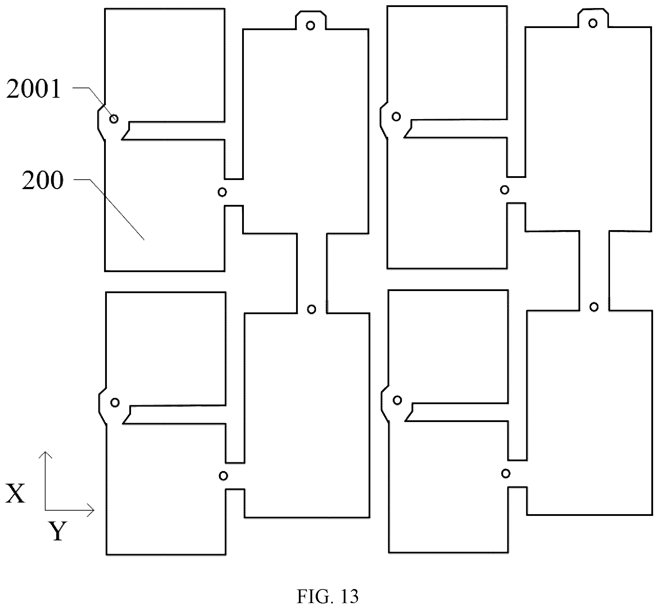

For example, as shown in FIG. 13, the defining structures 200 corresponding to one column of pixel units can be an integrated structure, and the defining structures corresponding to two adjacent columns of pixel units are spaced apart from each other and independently arranged. For example, the defining structure 200 corresponding to one column of pixel units can be a mesh structure. For example, the connection portion of the defining structure 200 corresponding to two adjacent pixel units in the same column overlaps with the connection electrode of the first sub-pixel. Of course, the embodiment of the present disclosure is not limited thereto, and the position of the connecting portion of the defining structure can be set according to the needs of the product.

The arrangement manners of the defining structures shown in FIGS. 12 and 13 are helpful to reduce the probability of peeling of the defining structures.

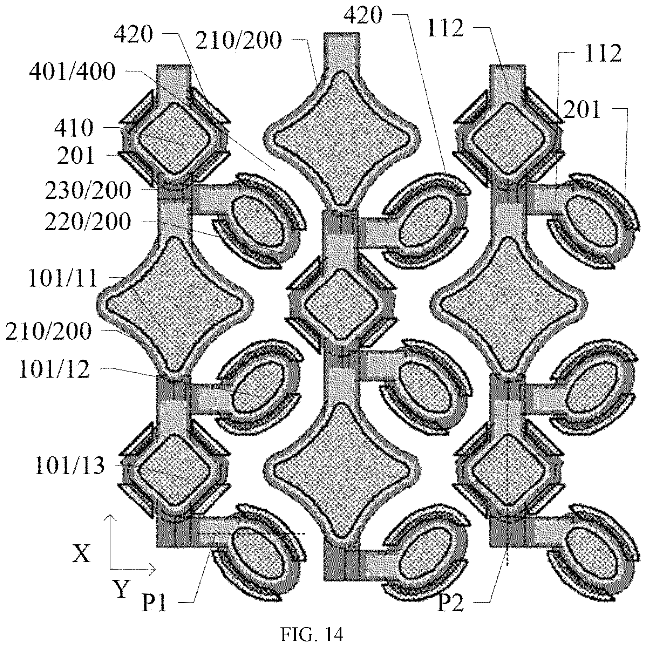

FIG. 14 is a partial structural view of a display substrate according to an example of another embodiment of the present disclosure. The features of the display substrate shown in FIG. 14, such as the base substrate, the laminated structure of the sub-pixel, and the shape and area of each color sub-pixel corresponding to the first opening in the pixel defining pattern, are the same as those of the display substrate shown in FIGS. 1-4.

As shown in FIG. 14, the display substrate includes a base substrate (referring to the base substrate 01 in FIG. 2), and a plurality of sub-pixels 10, a pixel defining pattern 400 and a defining structure 200 located on the base substrate. Each sub-pixel 10 in at least part of the sub-pixels 10 includes a light-emitting functional layer 130 (referring to the light-emitting functional layer 130 in FIG. 2), and the light-emitting functional layer includes a plurality of film layers. The features of the light-emitting functional layer of the sub-pixel in the display substrate shown in FIG. 14 can refer to the features of the light-emitting functional layer in the display substrate shown in FIGS. 1-4. For example, at least one film layer of the light-emitting functional layer (referring to FIG. 2) includes a charge generation layer; the light-emitting functional layer includes a first light-emitting layer, a charge generation layer and a second light-emitting layer which are stacked, the charge generation layer is located between the first light-emitting layer and the second light-emitting layer, and the charge generation layer is disconnected at the edge of the defining structure.

As shown in FIG. 14, the pixel defining pattern 400 includes a plurality of first openings 410 to define the light-emitting regions 101 of at least part of the sub-pixels 10, the pixel defining pattern 400 further includes a plurality of second openings 420, a portion of the at least one film layer of the light-emitting functional layer located in the first opening 410 is a continuous portion, and at least a portion of the at least one film layer of the light-emitting functional layer located in at least one second opening 420 is isolated.

As shown in FIG. 14, the defining structure 200 is located between the light-emitting functional layer and the base substrate (referring to the positional relationship among the defining structure, the light-emitting functional layer and the base substrate shown in FIG. 2), and a portion of the defining structure 200 exposed by the second opening 420 is configured to isolate at least one film layer of the light-emitting functional layer. The way in which the defining structure exposed by the second opening isolates the light-emitting functional layer in the display substrate shown in FIG. 14 can refer to the way in which the defining structure exposed by the second opening isolates the light-emitting functional layer in the display substrate shown in FIGS. 1-4.

As shown in FIG. 14, the plurality of sub-pixels 10 include a first sub-pixel 11 and a second sub-pixel 12 adjacent to each other, the turn-on voltage of the first sub-pixel 11 is higher than the turn-on voltage of the second sub-pixel 12, and at least part of an edge of the defining structure 200 exposed by the second opening 420 between the first sub-pixel 11 and the second sub-pixel 12 is closer to the light-emitting region 101 of the second sub-pixel 12.

In the display substrate provided by the present disclosure, by setting the edge of the defining structure exposed by the second opening closer to the second sub-pixel with a lower turn-on voltage, the second electrode of the first sub-pixel with a higher turn-on voltage has a conductive channel with a larger area, and the conductive effect of the second electrode of the first sub-pixel is improved, which is helpful to avoid high power consumption and brightness uniformity issues of the display substrate.

In the display substrate provided by the present disclosure, the turn-on voltage and power consumption of the first sub-pixel are relatively high, and the voltage (e.g., VSS voltage) of the display substrate for realizing white light is limited by the voltage difference between the first electrode and the second electrode of the first sub-pixel; for example, the first sub-pixel needs to have a larger cross-voltage between the first electrode and the second electrode. By setting the positional relationship of the first defining opening surrounding the first sub-pixel and the defining structure, the second electrode of the first sub-pixel has a conductive channel with a larger area, and the conductive effect of the second electrode of the first sub-pixel is improved, which is helpful to avoid high power consumption and brightness uniformity issues of the display substrate.

FIG. 14 illustratively shows that the first sub-pixel 11 and the second sub-pixel 12 are sub-pixels configured to emit light of different colors, but it is not limited thereto, and the first sub-pixel and the second sub-pixel can also be sub-pixels configured to emit light of the same color.

In some examples, as shown in FIG. 14, the plurality of sub-pixels include a plurality of red sub-pixels 13 and a plurality of green sub-pixels 12, the number of the second openings 420 surrounding the same green sub-pixel 12 is plural, and the lengths of at least two second openings 420 surrounding the same green sub-pixel 12 are different; the number of the second openings 420 surrounding the same red sub-pixel 13 is plural, and the lengths of at least two second openings 420 surrounding the same red sub-pixel 13 are the same.

For example, as shown in FIG. 14, the number of second openings 420 surrounding the same green sub-pixel 12 is different from the number of second openings 420 surrounding the same red sub-pixel 13. For example, the number of second openings 420 surrounding the same green sub-pixel 12 is less than the number of second openings 420 surrounding the same red sub-pixel 13.

For example, as shown in FIG. 14, the turn-on voltage of the first sub-pixel 11 is 0.1V to 5V higher than the turn-on voltage of the second sub-pixel 12. For example, the turn-on voltage of the first sub-pixel 11 is 0.1V to 5V higher than the turn-on voltage of the third sub-pixel 13. For example, the turn-on voltage can refer to the voltage applied to the element when the luminous brightness is 1cd/m², and it can also be called the luminous threshold voltage.

For example, the turn-on voltage of the first sub-pixel 11 is 0.5V to 4.5V higher than the turn-on voltage of the second sub-pixel 12. For example, the turn-on voltage of the first sub-pixel 11 is 1V to 4V higher than the turn-on voltage of the second sub-pixel 12. For example, the turn-on voltage of the first sub-pixel 11 is 1.5V to 3.5V higher than the turn-on voltage of the second sub-pixel 12. For example, the turn-on voltage of the first sub-pixel 11 is 2V to 3V higher than the turn-on voltage of the second sub-pixel 12. For example, the turn-on voltage of the first sub-pixel 11 is 0.5V to 4.5V higher than the turn-on voltage of the third sub-pixel 13 (described later). For example, the turn-on voltage of the first sub-pixel 11 is 1V to 4V higher than the turn-on voltage of the third sub-pixel 13. For example, the turn-on voltage of the first sub-pixel 11 is 1.5V to 3.5V higher than the turn-on voltage of the third sub-pixel 13. For example, the turn-on voltage of the first sub-pixel 11 is 2V to 3V higher than the turn-on voltage of the third sub-pixel 13. For example, the turn-on voltage of the first sub-pixel 11 is 1.5V higher than the turn-on voltage of the second sub-pixel 12. For example, the turn-on voltage of the first sub-pixel 11 is 1.5V higher than the turn-on voltage of the third sub-pixel 13. For example, the turn-on voltage of the red sub-pixel is slightly greater than the turn-on voltage of the green sub-pixel.

For example, the power consumption of the first sub-pixel 11 is greater than the power consumption of the second sub-pixel 12, and is greater than the power consumption of the third sub-pixel 13.

In some examples, as shown in FIG. 14, the first sub-pixel 11 is a blue sub-pixel, and the second sub-pixel 12 is one of a red sub-pixel and a green sub-pixel. FIG. 14 illustratively shows that the second sub-pixel 12 is a green sub-pixel, but it is not limited thereto, and the second sub-pixel can also be a red sub-pixel.

In some examples, as shown in FIG. 14, a portion of the defining structure 200 exposed by the second opening 420 arranged between the first sub-pixel 11 and the second sub-pixel 12 includes an annular defining edge 201, and the annular defining edge 201 surrounds the light-emitting region 101 of the second sub-pixel 12.

For example, as shown in FIG. 14, the defining structure 200 includes a second annular defining structure 220 surrounding the light-emitting region 101 of the second sub-pixel 12, and a portion of the second annular defining structure 220 exposed by the second opening 420 includes an annular defining edge 201, and the second annular defining structure 220 further includes a portion not exposed by the second opening 420.

In some examples, as shown in FIG. 14, the annular defining edge 201 is a non-closed structure. For example, the portion of the second annular defining structure 220 exposed by the second opening 420 and the portion of the second annular defining structure 220 not exposed by the second opening 420 are alternately arranged.

For example, as shown in FIG. 14, the area of the portion of the second annular defining structure 220 exposed by the second opening 420 is greater than the area of the portion of the second annular defining structure 220 not exposed by the second opening 420.

By adjusting the size relationship between the area of the portion of the second annular defining structure exposed by the second opening and the area of the portion of the second annular defining structure not exposed by the second opening, it is helpful to balance the degree of crosstalk between the first sub-pixel and the second sub-pixel, and the degree of conduction of the second electrode.

The second annular defining structure in the display substrate shown in FIG. 14 can have the same features of the second annular defining structure in the display substrate shown in FIGS. 1-4, and details will not be repeated here.

For example, as shown in FIG. 14, the defining structure 200 includes a first annular defining structure 210 surrounding the light-emitting region 101 of the first sub-pixel 11, and the first annular defining structure 210 is not exposed by the second opening 420, which is helpful to realize that the conductive channel of the second electrode has a larger size.

In some examples, as shown in FIG. 14, the plurality of sub-pixels 10 further include a third sub-pixel 13, and the annular defining edge 201 surrounds the light-emitting regions 101 of the second sub-pixel 12 and the third sub-pixel 13. For example, the third sub-pixel 13 can be a red sub-pixel. The arrangement manner of the plurality of sub-pixels shown in FIG. 14 can be the same as the arrangement manner of the plurality of sub-pixels shown in FIG. 1, and details will not be repeated here.

For example, as shown in FIG. 14, the defining structure 200 includes a third annular defining structure 230 surrounding the light-emitting region 101 of the third sub-pixel 13, and a portion of the third annular defining structure 230 exposed by the second opening 420 includes an annular defining edge 201, and the third annular defining structure 230 further includes a portion not exposed by the second opening 420. For example, the portion of the third annular defining structure 230 exposed by the second opening 420 and the portion of the third annular defining structure 230 not exposed by the second opening 420 are alternately arranged.

For example, as shown in FIG. 14, the area of the portion of the third annular defining structure 230 exposed by the second opening 420 is greater than the area of the portion of the third annular defining structure 230 not exposed by the second opening 420.

By adjusting the size relationship between the area of the portion of the third annular defining structure exposed by the second opening and the area of the portion of the third annular defining structure not exposed by the second opening, it is helpful to balance the degree of crosstalk between the first sub-pixel and the second sub-pixel, the degree of crosstalk between the first sub-pixel and the third sub-pixel, the degree of crosstalk between the second sub-pixel and the third sub-pixel, and the degree of conduction of the second electrode.

In some examples, as shown in FIG. 14, the light-emitting region 101 of the first sub-pixel 11 includes four curved sides and four corners connecting the four curved sides, and the four curved sides are all bent towards the center of the light-emitting region 101 of the first sub-pixel 11. For example, the four corners of the light-emitting region 101 of the first sub-pixel 11 can be rounded corners.

In some examples, as shown in FIG. 14, the shape of the light-emitting region 101 of the second sub-pixel 12 includes an ellipse or a circle, and the second opening 420 surrounds the edge of the light-emitting region 101 of the second sub-pixel 12. For example, the shape of the second opening 420 is substantially the same as the shape of the portion of the light-emitting region 101 of the second sub-pixel 12 that is surrounded. For example, the shape of the light-emitting region 101 of the second sub-pixel 12 is an ellipse, the extension line of the long axis of the ellipse does not pass through the second opening 420, and the extension line of the short axis of the ellipse passes through the second opening 420 twice. By setting the relative positional relationship among the long and short axes of the ellipse and the second defining opening, it is helpful to isolate the common layer in the light-emitting functional layers of two adjacent sub-pixels which are prone to crosstalk, and at the same time, increase the area of the communication channel of the second electrode as much as possible.

For example, as shown in FIG. 14, the shape of the light-emitting region of the third sub-pixel 13 includes a quadrangle, such as a rounded quadrangle; and the second opening 420 surrounds the edge of the light-emitting region 101 of the third sub-pixel 13. For example, the shape of the second opening 420 is substantially the same as the shape of the portion of the light-emitting region 101 of the third sub-pixel 13 that is surrounded.

For example, as shown in FIG. 14, the number of second openings 420 exposing the third annular defining structure 230 surrounding the light-emitting region 101 of the third sub-pixel 13 is plural, where at least one second opening 420 is opposite to a straight side of the light-emitting region 101 of the third sub-pixel 13, and the planar pattern of the second opening 420 cut by the XY plane is a trapezoid, and the upper base of the trapezoid is closer to the light-emitting region 101 of the third sub-pixel 13 than the lower base of the trapezoid is. By setting the shape of the second opening surrounding the straight side of the third sub-pixel to be a trapezoid and the upper base of the trapezoid is closer to the light-emitting region than the lower base of the trapezoid is, it is helpful to improve the isolating effect on the light-emitting functional layer.

For example, as shown in FIG. 14, the second opening 420 exposing the third annular defining structure 230 of the third sub-pixel 13 is located between the second sub-pixel 12 and the third sub-pixel 13, and the second opening 420 is opposite to a portion of the second annular defining structure 220 of the second sub-pixel 12 that is not exposed by the second opening 420, which is helpful to balance the crosstalk between adjacent pixels and the conductive effect of the second electrode.

In some examples, referring to FIGS. 3, 4 and 14, each of the at least part of the sub-pixels further includes a pixel circuit 03, and a first electrode 110 and a second electrode 120 located at both sides of the light-emitting functional layer 130, the first electrode 110 is located between the light-emitting functional layer 130 and the base substrate, the first electrode 110 includes a main electrode 111 and a connection electrode 112, the connection electrode 112 does not overlap with the light-emitting region 101 in the direction perpendicular to the base substrate, and the connection electrode 112 is electrically connected with the pixel circuit 03 through a connection via hole 2001; the plurality of green sub-pixels 12 are arrayed along a row direction and a column direction, the connection electrode 112 of the red sub-pixel 13 extends along one of the row direction and the column direction, and the connection electrode 112 of the green sub-pixel 12 extends along the other of the row direction and the column direction.

In some examples, as shown in FIG. 14, the connection electrode 112 of the red sub-pixel 13 extends along the column direction, and the connection electrode 112 of the green sub-pixel 12 extends along the row direction; the extension line of an edge, extending along the column direction, of the connection electrode 112 of the red sub-pixel 13 does not pass through the second opening 420 surrounding the red sub-pixel 13, and the extension line of an edge, extending along the row direction, of the connection electrode 112 of the green sub-pixel 12 passes through the second opening 420 surrounding the green sub-pixel 12.

In some examples, as shown in FIG. 14, the number of second openings 420 surrounding the green sub-pixel 12 is two, a straight line P1 passing through the center of the connection via hole of the green sub-pixel 12 and extending along the row direction passes through only one second opening 420, and a straight line P2 passing through the center of the connection via hole of the red sub-pixel 13 and extending along the column direction does not pass through the second opening 420 surrounding the red sub-pixel. For example, one of the two second openings 420 surrounding the green sub-pixel 12 is completely located at a first side of the connection electrode 112, e.g., at a first side of a center line, extending along the Y direction, of the connection electrode 112; and more than 50% of the other second opening 420 of the two second openings 420 is located at a second side of the center line, extending along the Y direction, of the connection electrode 112.

For example, as shown in FIG. 14, the number of second openings 420 surrounding the red sub-pixel 13 is four, and at least two second openings 420 of the four second openings 420 have the same length. For example, the lengths of the four second openings 420 are all the same.

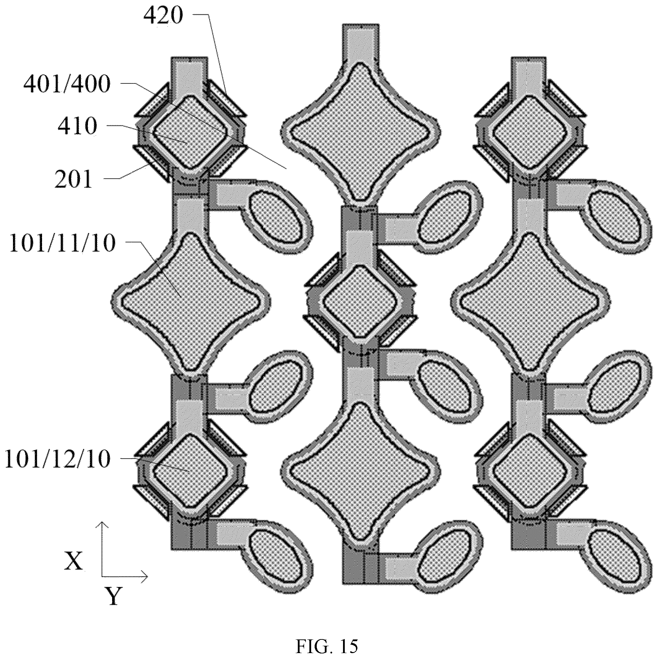

FIG. 15 is a partial structural view of a display substrate according to another example of another embodiment of the present disclosure. In the display substrate shown in FIG. 15, the second sub-pixel 12 can be a red sub-pixel, and the third sub-pixel 13 can be a green sub-pixel. The display substrate shown in FIG. 15 is different from the display substrate shown in FIG. 14 in that the annular defining edge 201 surrounds the light-emitting region 101 of one of the second sub-pixel 12 and the third sub-pixel 13. For example, the annular defining edge 201 surrounds the light-emitting region 101 of the second sub-pixel 12.

For example, as shown in FIG. 15, only the annular defining structure surrounding the light-emitting region 101 of the second sub-pixel 12 is exposed by the second opening 420.

In the display substrate provided by the present disclosure, because of the tendency of the red sub pixel to light up when it should not, by setting that only the annular defining structure surrounding the light-emitting region of the red sub-pixel is exposed by the second opening, the crosstalk of the red sub-pixel to other color sub-pixels can be reduced, and at the same time, the conductive effect of the second electrode can be greatly improved.

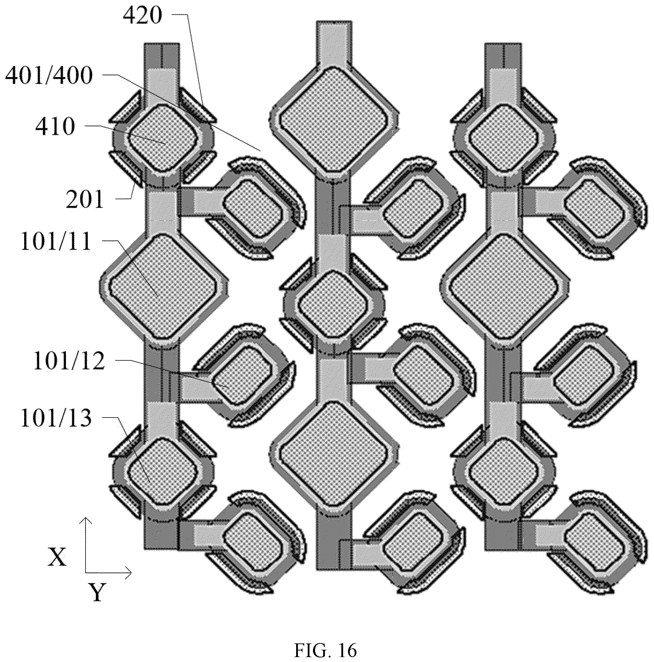

FIG. 16 is a partial structural view of a display substrate according to another example of another embodiment of the present disclosure. The display substrate shown in FIG. 16 is different from the display substrate shown in FIG. 14 in that: the shape of the light-emitting region 101 of the first sub-pixel 11 in the display substrate shown in FIG. 16 is different from the shape of the light-emitting region 101 of the first sub-pixel 11 in the display substrate shown in FIG. 14, and the shape of the light-emitting region 101 of the second sub-pixel 12 in the display substrate shown in FIG. 16 is different from the shape of the light-emitting region 101 of the second sub-pixel 12 in the display substrate shown in FIG. 14. For example, the first sub-pixel 11 is a blue sub-pixel, the second sub-pixel 12 is a green sub-pixel, and the third sub-pixel 13 is a red sub-pixel.

In some examples, as shown in FIG. 16, the blue sub-pixels 11 and the red sub-pixels 13 are alternately arranged along a first direction as a first sub-pixel group, the green sub-pixels 12 are arranged along the first direction as a second sub-pixel group, the first sub-pixel group and the second sub-pixel group are alternately arranged along a second direction, and the second direction intersects with the first direction; the centers of a certain blue sub-pixel 11 and a certain red sub-pixel 13 adjacent to each other in the same first sub-pixel group, and the centers of one blue sub-pixel 11 and one red sub-pixel 13, which are located in an adjacent first sub-pixel group and are respectively adjacent to the certain blue sub-pixel 11 and the certain red sub-pixel 13 adjacent to each other in the second direction, are taken as four vertices of a virtual trapezoid, and one green sub-pixel 12 is arranged in the virtual trapezoid. The shapes and arrangement of the sub-pixels shown in FIG. 16 can be the same as the shapes and arrangement of the sub-pixels shown in FIG. 5, and details will not be repeated here.

For example, as shown in FIG. 16, the number of second openings 420 exposing the annular defining structure surrounding the light-emitting region 101 of the same second sub-pixel 12 can be plural, and the plurality of second openings 420 surround two sides and three corners of the light-emitting region 101.

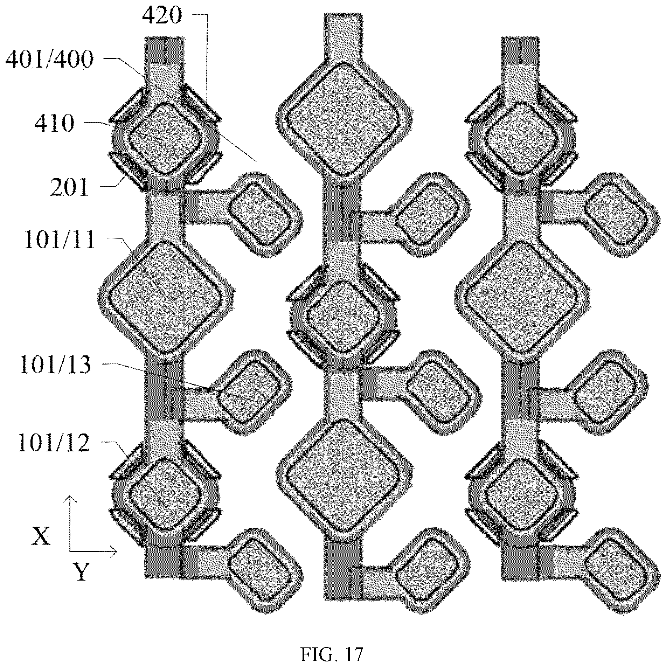

FIG. 17 is a partial structural view of a display substrate according to another example of another embodiment of the present disclosure. In the display substrate shown in FIG. 17, the second sub-pixel 12 can be a red sub-pixel, and the third sub-pixel 13 can be a green sub-pixel. The display substrate shown in FIG. 17 is different from the display substrate shown in FIG. 16 in that the annular defining edge 201 surrounds the light-emitting region 101 of one of the second sub-pixel 12 and the third sub-pixel 13. For example, the annular defining edge 201 surrounds the light-emitting region 101 of the second sub-pixel 12.

For example, as shown in FIG. 17, only the annular defining structure surrounding the light-emitting region 101 of the second sub-pixel 12 is exposed by the second opening 420.

In the display substrate provided by the present disclosure, because of the tendency of the red sub pixel to light up when it should not, by setting that only the annular defining structure surrounding the light-emitting region of the red sub-pixel is exposed by the second opening, the crosstalk of the red sub-pixel to other color sub-pixels can be reduced, and at the same time, the conductive effect of the second electrode can be greatly improved.

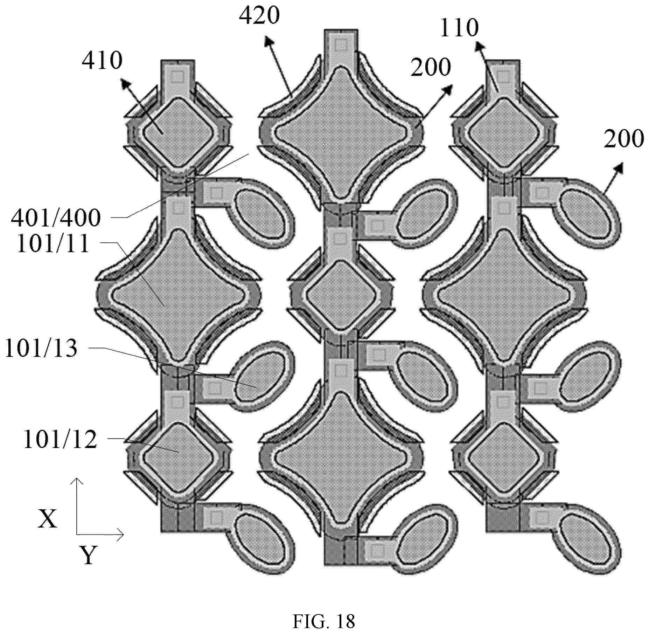

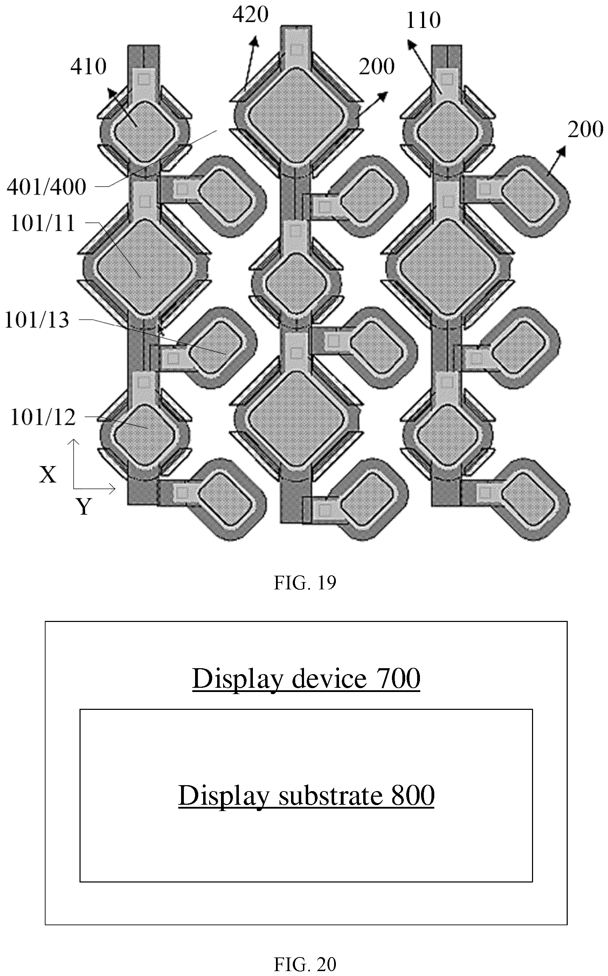

FIGS. 18 and 19 are partial structural views of a display substrate according to different embodiments of the present disclosure.

The display substrate shown in FIG. 18 is different from the display substrate shown in FIG. 15 in that an edge of the defining structure 200 surrounding the light-emitting region 101 of the first sub-pixel 11 is exposed by the second opening 420. Other features of the display substrate shown in FIG. 18 can be the same as those of the display substrate shown in FIG. 15, and details will not be repeated here.

The display substrate shown in FIG. 19 is different from the display substrate shown in FIG. 17 in that an edge of the defining structure 200 surrounding the light-emitting region 101 of the first sub-pixel 11 is exposed by the second opening 420. Other features of the display substrate shown in FIG. 19 can be the same as those of the display substrate shown in FIG. 17, and details will not be repeated here.

FIG. 20 is a schematic block diagram of a display device according to another embodiment of the present disclosure. Another embodiment of the present disclosure provides a display device, and the display device 700 includes any display substrate 800 described above.

For example, the display device further includes a cover plate located at a light-exiting side of the display substrate.

For example, the display device can be a display device such as an organic light-emitting diode display device, etc., and any product or component having display function and including the display device, such as a TV, a digital camera, a mobile phone, a watch, a tablet computer, a notebook computer, a navigator, etc. The present embodiment is not limited thereto.

The following statements should be noted:
(1) In the accompanying drawings of the embodiments of the present disclosure, the drawings involve only the structure(s) in connection with the embodiment(s) of the present disclosure, and other structure(s) can be referred to common design(s).
(2) In case of no conflict, features in one embodiment or in different embodiments can be combined.

What have been described above are only specific implementations of the present disclosure, the protection scope of the present disclosure is not limited thereto, and the protection scope of the present disclosure should be based on the protection scope of the claims.

## Claims

1. A display substrate, comprising:
a base substrate;
a plurality of sub-pixels located on the base substrate, wherein each sub-pixel in at least part of the plurality of sub-pixels comprises a light-emitting functional layer, and the light-emitting functional layer comprises a plurality of film layers;
a pixel defining pattern located on the base substrate, wherein the pixel defining pattern comprises a plurality of first openings to define light-emitting regions of the at least part of the plurality of sub-pixels, the pixel defining pattern further comprises a plurality of second openings, a portion of at least one film layer of the light-emitting functional layer located in the first opening is a continuous portion, and a portion of the at least one film layer of the light-emitting functional layer located in at least one second opening is isolated from a portion of the at least one film layer of the light-emitting functional layer located at an outer side of the at least one second opening;
a defining structure located between the light-emitting functional layer and the base substrate, wherein a portion of the defining structure exposed by the second opening is configured to isolate the at least one film layer of the light-emitting functional layer,
wherein the plurality of sub-pixels comprise a first sub-pixel, the plurality of second openings comprise a first defining opening, and the first defining opening exposes a portion of the defining structure surrounding a light-emitting region of the first sub-pixel,
a straight line passing through a center of the light-emitting region of the first sub-pixel and extending along a first direction is a first straight line, and a length of a portion of the first defining opening located at a first side of the first straight line is not less than a length of a portion of the first defining opening located at a second side of the first straight line;
a center connection line of at least one sub-pixel and at least another sub-pixel adjacent thereto among the plurality of sub-pixels does not pass through any of the plurality of second openings.

2. The display substrate according to claim 1, wherein the plurality of sub-pixels are arranged as a plurality of sub-pixel rows, sub-pixels in each sub-pixel row are arranged along a row direction, and the plurality of sub-pixel rows are arranged along a column direction;
light-emitting regions of adjacent sub-pixels arranged along at least one of the row direction and the column direction are passed through by a same straight line, and the same straight line does not pass through the second opening.

3. The display substrate according to claim 1 or 2, wherein the plurality of sub-pixels further comprise a second sub-pixel, the plurality of second openings further comprise a second defining opening, and the second defining opening exposes a portion of the defining structure surrounding a light-emitting region of the second sub-pixel,
a straight line passing through a center of the light-emitting region of the second sub-pixel and extending along the first direction is a second straight line, a length of a portion of the second defining opening located at a first side of the second straight line is not less than a length of a portion of the second defining opening located at a second side of the second straight line, and a relative positional relationship between the first side and the second side of the first straight line is the same as a relative positional relationship between the first side and the second side of the second straight line.

4. The display substrate according to claim 3, wherein a turn-on voltage of the first sub-pixel is higher than a turn-on voltage of the second sub-pixel.

5. The display substrate according to claim 3 or 4, wherein the first defining opening is only located at the first side of the first straight line, and at least 60% of the second defining opening is located at the first side of the second straight line.

6. The display substrate according to any one of claims 3-5, wherein the light-emitting region of the first sub-pixel comprises a first axis of symmetry, the light-emitting region of the second sub-pixel comprises a second axis of symmetry, an area of a portion of the first defining opening located at a first side of the first axis of symmetry is not less than an area of a portion of the first defining opening located at a second side of the first axis of symmetry, an area of a portion of the second defining opening located at a first side of the second axis of symmetry is not less than an area of a portion of the second defining opening located at a second side of the second axis of symmetry, and an extending direction of the first axis of symmetry intersects with an extending direction of the second axis of symmetry.

7. The display substrate according to any one of claims 3-6, wherein each sub-pixel in the at least part of the plurality of sub-pixels further comprises a pixel circuit, and a first electrode and a second electrode located at both sides of the light-emitting functional layer, the first electrode is located between the light-emitting functional layer and the base substrate, the first electrode comprises a main electrode and a connection electrode, the connection electrode does not overlap with the light-emitting region in a direction perpendicular to the base substrate, the connection electrode is electrically connected with the pixel circuit through a connection via hole, and the second opening does not overlap with the connection via hole in the direction perpendicular to the base substrate.

8. The display substrate according to claim 7, wherein the defining structure comprises a first annular defining structure surrounding the main electrode of the first sub-pixel, and an area of a portion of the first annular defining structure not exposed by the first defining opening is not less than an area of a portion of the first annular defining structure exposed by the first defining opening.

9. The display substrate according to claim 7 or 8, wherein the defining structure further comprises a second annular defining structure surrounding the main electrode of the second sub-pixel, and an area of a portion of the second annular defining structure not exposed by the second defining opening is not less than an area of a portion of the second annular defining structure exposed by the second defining opening.

10. The display substrate according to any one of claims 7-9, wherein, in the first sub-pixel, an included angle between a connection line from the connection via hole to the center of the light-emitting region and the first straight line is a first included angle; in the second sub-pixel, an included angle between a connection line from the connection via hole to the center of the light-emitting region and the first straight line is a second included angle; and the second included angle is greater than the first included angle.

11. The display substrate according to claim 10, wherein, in the first sub-pixel, an extension line of the connection line from the connection via hole to the center of the light-emitting region does not pass through the second opening surrounding the first sub-pixel; and in the second sub-pixel, an extension line of the connection line from the connection via hole to the center of the light-emitting region passes through the second opening surrounding the second sub-pixel.

12. The display substrate according to any one of claims 3-11, wherein any straight line extending along a second direction passes through the second defining opening surrounding a same second sub-pixel at most once, and the second direction intersects with the first direction.

13. The display substrate according to any one of claims 3-12, wherein the first defining opening surrounding a same first sub-pixel is a continuous opening or a discontinuous opening, and the second defining opening surrounding a same second sub-pixel is a continuous opening or a discontinuous opening.

14. The display substrate according to any one of claims 3-13, wherein the light-emitting region of the first sub-pixel comprises four curved sides and four corners connecting the four curved sides, the four curved sides are all bent towards the center of the light-emitting region of the first sub-pixel, the first defining opening surrounds at most two curved sides of the four curved sides and at most one corner of the four corners, and the first defining opening extends along an edge of a surrounded portion of the light-emitting region of the first sub-pixel;
a shape of the light-emitting region of the second sub-pixel comprises an ellipse or a circle, and the second defining opening extends along an edge of a surrounded portion of the light-emitting region of the second sub-pixel.

15. The display substrate according to any one of claims 3-13, wherein the light-emitting region of the first sub-pixel comprises four straight sides and four corners connecting the four straight sides, and the first defining opening surrounds at most two straight sides of the four straight sides and at most one corner of the four comers;
the light-emitting region of the second sub-pixel comprises four straight sides and four corners connecting the four straight sides, and the second defining opening surrounds at least two straight sides of the four straight sides and at least two corners of the four corners.

16. The display substrate according to any one of claims 3-13, wherein the light-emitting region of the first sub-pixel comprises four straight sides and four corners connecting the four straight sides, and the first defining opening surrounds at least one straight side of the four straight sides and at most one corner of the four corners;
the light-emitting region of the second sub-pixel comprises four straight sides and four corners connecting the four straight sides, and the second defining opening surrounds at least one straight side of the four straight sides and at most one corner of the four corners.

17. The display substrate according to any one of claims 3-12, wherein a count of first sub-pixels is plural, a count of second sub-pixels is plural, and a plurality of first sub-pixels and a plurality of second sub-pixels comprise a first sub-pixel and a second sub-pixel adjacent to each other;
one of the first defining opening and the second defining opening is arranged between the first sub-pixel and the second sub-pixel adjacent to each other, and the first defining opening between the first sub-pixel and the second sub-pixel adjacent to each other is closer to an edge of the light-emitting region of the first sub-pixel, or the second defining opening between the first sub-pixel and the second sub-pixel adjacent to each other is closer to an edge of the light-emitting region of the second sub-pixel.

18. The display substrate according to any one of claims 3-5, wherein the plurality of sub-pixels further comprise a third sub-pixel, the plurality of second openings further comprise a third defining opening, and the third defining opening exposes a portion of the defining structure surrounding a light-emitting region of the third sub-pixel,
a straight line passing through a center of the light-emitting region of the third sub-pixel and extending along the first direction is a third straight line, an area of a portion of the third defining opening located at a first side of the third straight line is not less than an area of a portion of the third defining opening located at a second side of the third straight line, and a relative positional relationship between the first side and the second side of the third straight line is the same as the relative positional relationship between the first side and the second side of the first straight line.

19. The display substrate according to claim 18, wherein the first sub-pixel is a blue sub-pixel, one of the second sub-pixel and the third sub-pixel is a red sub-pixel, and the other of the second sub-pixel and the third sub-pixel is a green sub-pixel.

20. The display substrate according to claim 18 or 19, wherein the light-emitting region of the third sub-pixel comprises a third axis of symmetry, and an area of a portion of the third defining opening located at a first side of the third axis of symmetry is not less than an area of a portion of the third defining opening located at a second side of the third axis of symmetry.

21. The display substrate according to any one of claims 18-20, wherein each sub-pixel in the at least part of the plurality of sub-pixels further comprises a pixel circuit, and a first electrode and a second electrode located at both sides of the light-emitting functional layer, the first electrode is located between the light-emitting functional layer and the base substrate, the first electrode comprises a main electrode and a connection electrode, the connection electrode does not overlap with the light-emitting region in a direction perpendicular to the base substrate, and the connection electrode is electrically connected with the pixel circuit;
the defining structure comprises a third annular defining structure surrounding the main electrode of the third sub-pixel, and an area of a portion of the third annular defining structure not exposed by the third defining opening is not less than an area of a portion of the third annular defining structure exposed by the third defining opening.

22. The display substrate according to any one of claims 18-21, wherein a count of first sub-pixels is plural, a count of second sub-pixels is plural, a count of third sub-pixels is plural, the first sub-pixels and the third sub-pixels are alternately arranged along the first direction as a first sub-pixel group, the second sub-pixels are arranged along the first direction as a second sub-pixel group, and the first sub-pixel group and the second sub-pixel group are alternately arrange along a second direction; centers of a certain first sub-pixel and a certain third sub-pixel adjacent to each other in a same first sub-pixel group, and centers of one first sub-pixel and one third sub-pixel, which are located in an adjacent first sub-pixel group and are respectively adjacent to the certain first sub-pixel and the certain third sub-pixel adjacent to each other in the second direction, are taken as four vertices of a virtual trapezoid, and one second sub-pixel is arranged in the virtual trapezoid.

23. The display substrate according to claim 7 or 21, wherein the defining structure comprises a defining connection structure stacked with the connection electrode, and the second opening extends to an edge of the defining connection structure corresponding to the connection electrodes of part of the plurality of sub-pixels.

24. The display substrate according to claim 23, wherein the plurality of sub-pixels comprise a plurality of pixel units arrayed along the first direction and a second direction, each of the plurality of pixel units comprises one first sub-pixel, one second sub-pixel and one third sub-pixel, and the second direction intersects with the first direction;
in each of the plurality of pixel units, the second sub-pixel and the third sub-pixel are alternately arranged along the first direction, and the first sub-pixel and the third sub-pixel are alternately arranged along the second direction;
in the first sub-pixel, the connection electrode is located at one side of the main electrode in the first direction; in the second sub-pixel, the connection electrode is located at one side of the main electrode in the second direction; in the third sub-pixel, the connection electrode is located at one side of the main electrode in the first direction.

25. The display substrate according to any one of claims 1-24, wherein at least one film layer of the light-emitting functional layer comprises a charge generation layer, the light-emitting functional layer comprises a first light-emitting layer, the charge generation layer and a second light-emitting layer which are stacked, the charge generation layer is located between the first light-emitting layer and the second light-emitting layer, and the charge generation layer is disconnected at an edge of the defining structure.

26. A display substrate, comprising:
a base substrate;
a plurality of sub-pixels located on the base substrate, wherein each sub-pixel in at least part of the plurality of sub-pixels comprises a light-emitting functional layer, and the light-emitting functional layer comprises a plurality of film layers;
a pixel defining pattern located on the base substrate, wherein the pixel defining pattern comprises a plurality of first openings to define light-emitting regions of the at least part of the plurality of sub-pixels, the pixel defining pattern further comprises a plurality of second openings, a portion of at least one film layer of the light-emitting functional layer located in the first opening is a continuous portion, and a portion of the at least one film layer of the light-emitting functional layer located in at least one second opening is isolated from a portion of the at least one film layer of the light-emitting functional layer located at an outer side of the at least one second opening;
a defining structure located between the light-emitting functional layer and the base substrate, wherein a portion of the defining structure exposed by the second opening is configured to isolate the at least one film layer of the light-emitting functional layer,
wherein the plurality of sub-pixels comprise a first sub-pixel and a second sub-pixel adjacent to each other, a turn-on voltage of the first sub-pixel is higher than a turn-on voltage of the second sub-pixel, and at least part of an edge of the defining structure exposed by the second opening between the first sub-pixel and the second sub-pixel is closer to a light-emitting region of the second sub-pixel.

27. The display substrate of claim 26, wherein the first sub-pixel is a blue sub-pixel, and the second sub-pixel is one of a red sub-pixel and a green sub-pixel.

28. The display substrate according to claim 26, wherein the plurality of sub-pixels comprise a plurality of red sub-pixels and a plurality of green sub-pixels, a count of second openings surrounding a same green sub-pixel is plural, and lengths of at least two second openings surrounding the same green sub-pixel are different;
a count of second openings surrounding a same red sub-pixel is plural, and lengths of at least two second openings surrounding the same red sub-pixel are the same.

29. The display substrate according to claim 28, wherein each sub-pixel in the at least part of the plurality of sub-pixels further comprises a pixel circuit, and a first electrode and a second electrode located at both sides of the light-emitting functional layer, the first electrode is located between the light-emitting functional layer and the base substrate, the first electrode comprises a main electrode and a connection electrode, the connection electrode does not overlap with the light-emitting region in a direction perpendicular to the base substrate, and the connection electrode is electrically connected with the pixel circuit through a connection via hole;
the plurality of green sub-pixels are arrayed along a row direction and a column direction, the connection electrode of the red sub-pixel extends along one of the row direction and the column direction, and the connection electrode of the green sub-pixel extends along the other of the row direction and the column direction.

30. The display substrate according to claim 29, wherein the connection electrode of the red sub-pixel extends along the column direction, and the connection electrode of the green sub-pixel extends along the row direction; an extension line of an edge, extending along the column direction, of the connection electrode of the red sub-pixel does not pass through the second opening surrounding the red sub-pixel, and an extension line of an edge, extending along the row direction, of the connection electrode of the green sub-pixel passes through the second opening surrounding the green sub-pixel.

31. The display substrate according to claim 30, wherein a count of second openings surrounding the green sub-pixel is two, a straight line passing through a center of the connection via hole of the green sub-pixel and extending along the row direction passes through only one second opening, and a straight line passing through a center of the connection via hole of the red sub-pixel and extending along the column direction does not pass through the second opening surrounding the red sub-pixel.

32. The display substrate according to claim 26, wherein a portion of the defining structure exposed by the second opening arranged between the first sub-pixel and the second sub-pixel comprises an annular defining edge, and the annular defining edge surrounds the light-emitting region of the second sub-pixel.

33. The display substrate according to claim 32, wherein the annular defining edge is a non-closed structure.

34. The display substrate according to claim 26, wherein the plurality of sub-pixels further comprise a third sub-pixel, a portion of the defining structure exposed by the second opening comprises an annular defining edge, the annular defining edge surrounds a light-emitting region of one of the second sub-pixel and the third sub-pixel, or the annular defining edge surrounds light-emitting regions of the second sub-pixel and the third sub-pixel.

35. The display substrate according to any one of claims 26-34, wherein the light-emitting region of the first sub-pixel comprises four curved sides and four corners connecting the four curved sides, and the four curved sides are all bent towards a center of the light-emitting region of the first sub-pixel;
a shape of the light-emitting region of the second sub-pixel comprises an ellipse or a circle, and the second opening surrounds an edge of the light-emitting region of the second sub-pixel.

36. The display substrate according to claim 27, wherein blue sub-pixels and red sub-pixels are alternately arranged along a first direction as a first sub-pixel group, green sub-pixels are arranged along the first direction as a second sub-pixel group, the first sub-pixel group and the second sub-pixel group are alternately arrange along a second direction, and the second direction intersects with the first direction; centers of a certain blue sub-pixel and a certain red sub-pixel adjacent to each other in a same first sub-pixel group, and centers of one blue sub-pixel and one red sub-pixel, which are located in an adjacent first sub-pixel group and are respectively adjacent to the certain blue sub-pixel and the certain red sub-pixel adjacent to each other in the second direction, are taken as four vertices of a virtual trapezoid, and one green sub-pixel is arranged in the virtual trapezoid.

37. The display substrate according to any one of claims 26-36, wherein at least one film layer of the light-emitting functional layer comprises a charge generation layer, the light-emitting functional layer comprises a first light-emitting layer, the charge generation layer and a second light-emitting layer which are stacked, the charge generation layer is located between the first light-emitting layer and the second light-emitting layer, and the charge generation layer is disconnected at an edge of the defining structure.

38. A display device, comprising the display substrate according to any one of claims 1-37.
